(19) Europäisches Patentamt
European Patent Office
Office européen des brevets

(11) **EP 3 522 165 A1**

(12) # EUROPEAN PATENT APPLICATION

(43) Date of publication:
**07.08.2019 Bulletin 2019/32**

(51) Int Cl.:
***G11C 11/54*** *(2006.01)* ***G11C 16/04*** *(2006.01)*

(21) Application number: **18158099.4**

(22) Date of filing: **22.02.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **02.02.2018 US 201815887166**

(71) Applicant: **MACRONIX INTERNATIONAL CO., LTD.**
**Hsinchu 300 (TW)**

(72) Inventors:
- **LEE, Feng-Min**
  **300 Hsinchu (TW)**
- **LIN, Yu-Yu**
  **300 Hsinchu (TW)**

(74) Representative: **Gunzelmann, Rainer**
**Wuesthoff & Wuesthoff**
**Patentanwälte PartG mbB**
**Schweigerstraße 2**
**81541 München (DE)**

Remarks:
Amended claims in accordance with Rule 137(2) EPC.

(54) ## SUM-OF-PRODUCTS ARRAY FOR NEUROMORPHIC COMPUTING SYSTEM

(57) An array of variable resistance cells based on a programmable threshold transistor and a resistor connected in parallel is described. An input voltage applied to the transistor, and the programmable threshold of the transistor, can represent variables of sum-of-products operations. Programmable threshold transistors in the variable resistance cells comprise charge trapping memory transistors, such as floating gate transistors or dielectric charge trapping transistors. The resistor in the variable resistance cells can comprise a buried implant resistor connecting the current-carrying terminals (e.g. source and drain) of the programmable threshold transistor. A voltage sensing sense amplifier is configured to sense the voltage generated by the variable resistance cells as a function of an applied current and the resistance of the variable resistance cells.

FIG. 2

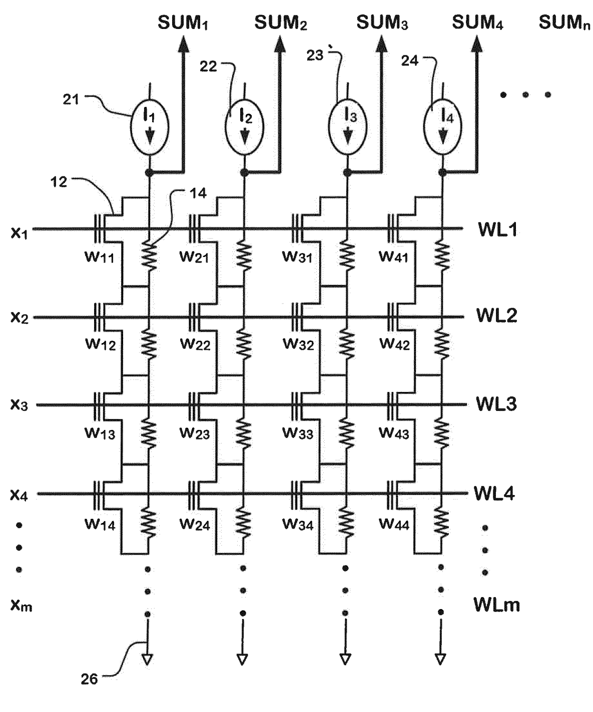


EP 3 522 165 A1

## Description

## BACKGROUND

### Field

The present invention relates to circuitry that can be used to perform or support sum-of-products operations.

### Description of Related Art

In neuromorphic computing systems, machine learning systems and circuitry used for some types of computation based on linear algebra, the sum-of-products function can be an important component. The function can be expressed as follows:

$$f(x_i) = \sum_{i=1}^{M} W_i x_i$$

In this expression, each product term is a product of a variable input $X_i$ and a weight $W_i$. The weight $W_i$ can vary among the terms, corresponding for example to coefficients of the variable inputs $X_i$.

The sum-of-products function can be realized as a circuit operation using cross-point array architectures in which the electrical characteristics of cells of the array effectuate the function.

For high-speed implementations, it is desirable to have a very large array so that many operations can be executed in parallel, or very large sum-of-products series can be performed. In the systems, there can be a very large number of inputs and outputs, so that the total current consumption can be very large.

It is desirable to provide structures for sum-of-products functions suitable for implementation in large arrays, and that can be more energy-efficient.

## SUMMARY

A device is described that comprises an array of variable resistance cells, where a variable resistance cell in the array comprises a programmable threshold transistor and a resistor connected in parallel. The device can be operated so that an input voltage applied to the transistor and the programmable threshold of the transistor can represent variables of sum-of-products operations. The variable resistance of each variable resistance cell, in embodiments described herein, is a function of a voltage applied to the control gate of the programmable threshold transistor in the cell, a threshold of the programmable threshold transistor, and the resistor.

The device in some embodiments includes a voltage sensing sense amplifier, configured to sense the voltage generated by the variable resistance cells, as a function of an applied current and the resistance of the variable resistance cells. In this manner, the magnitude of the current generated to produce the sum-of-products result can be limited or fixed, reducing the power consumption.

The array can be implemented using cells consisting of one transistor and one resistor (1T-1R). Furthermore, embodiments described herein can implement the resistor as a buried implant resistor within the layout footprint of a single variable threshold transistor, in effect making an array of one transistor (IT) cells, for a very compact layout configured for sum-of-products operations with voltage sensing.

Embodiments are described in which variable resistance cells in the array are configured in a plurality of strings of series-connected variable resistance cells. A plurality of word lines can be coupled to the strings of series-connected variable resistance cells. Word line drivers are connected to the plurality of word lines to apply variable gate voltages to the programmable threshold transistors in the variable resistance cells.

Furthermore, a device is described which comprises a plurality of strings of variable resistance cells; variable resistance cells in strings in the plurality of strings each having a first current-carrying node, a second current-carrying node, and a control terminal, and comprising a programmable threshold transistor and a resistor connected in parallel to the first and second current-carrying nodes, the programmable threshold transistor having a gate connected to the control terminal; and wherein: a variable resistance of each variable resistance cell in the strings is a function of a voltage applied to the control gate of the cell, a threshold of the programmable threshold transistor, and the resistor.

Embodiments are described in which the programmable threshold transistors in the variable resistance cells comprise charge trapping memory transistors, such as floating gate transistors or dielectric charge trapping transistors.

Embodiments are described in which the resistors in the variable resistance cells comprise a buried implant resistor connecting the current-carrying terminals (*e.g.* source and drain) of the programmable threshold transistor.

A device for generating sum-of-products data is provided that includes an array of variable resistance cells, variable resistance cells in the array each comprising a programmable threshold transistor and a resistor connected in parallel, the array including n columns of cells including strings of series connected cells and m rows of cells. Control and bias circuitry are coupled to the array, including logic for programming the programmable threshold transistors in the array with thresholds corresponding to values of a weight factor $W_{mn}$ for the corresponding cell. Input drivers are coupled to corresponding ones of the m rows of cells, the input drivers selectively applying inputs $X_m$ to rows m. Column drivers are configured to apply currents $I_n$ to corresponding ones of the n columns of cells. Voltage sensing circuits operatively coupled to the columns of cells.

A system including a memory array and a sum-of-products accelerator array interconnected using a data path controller is described. The sum-of-products accelerator array comprises an array of programmable resistance cells. The memory array can be used in coordination with the sum-of-products accelerator array for configuration and operation of the sum-of-products functions.

A method for operating an array of variable resistance cells to produce sum of products data comprises programming the programmable threshold transistors in the array with thresholds corresponding to values of a weight factor for the corresponding cell; selectively applying inputs to rows of cells in the array applying currents to corresponding ones of the columns of cells in the array; and sensing voltages on one or more of the columns of cells in the array.

Other aspects and advantages of the present invention can be seen on review of the drawings, the detailed description and the claims, which follow.

BRIEF DESCRIPTION OF THE DRAWINGS

Figure 1 is a functional diagram of a sum-of-products operation which can be a fundamental element of a neuromorphic computing system known in the prior art.

Figure 2 illustrates a portion of an array of variable resistance cells configured for sum-of-products operations.

Figure 3 is a schematic diagram of a variable resistance cell according to embodiments described herein.

Figure 4 is a simplified cross-section of a variable resistance cell including a floating gate memory transistor and a buried implant resistor.

Figure 5 is a simplified cross-section of a variable resistance cell including a dielectric charge trapping memory transistor and a buried implant resistor.

Figures 6-9 illustrate stages in a manufacturing process for a variable resistance cell according to an embodiment described herein.

Figures 10A and 10B are cross-section and layout views of variable resistance cells arranged in series in a NAND-like structure.

Figures 11A and 11B are illustrated to demonstrate operation of a variable resistance cell.

Figure 12 illustrates a string of variable resistance cells configured for implementation of a sum-of-products operation.

Figure 13 is a simplified block diagram of sensing circuitry that can be utilized with an array of variable resistance cells for the purposes of sum-of-products operations.

Figure 13A is a heuristic diagram referred to for the purposes of describing the sensing operations using the circuit of Figure 13.

Figure 14 is a simplified diagram of a reference voltage circuit that can be utilized with sensing circuitry like that of Figure 13.

Figure 15 illustrates a configuration of an array of variable resistance cells, including a reference string.

Figure 16 illustrates another configuration of an array of variable resistance cells, including a reference string and unused cells.

Figure 17 illustrates another configuration of an array of variable resistance cells including two reference strings and unused cells.

Figures 18-22 illustrates functional sets of variable resistance cells configured to implement terms of sum-of-products operations with multiple bit weights.

Figure 23 is a simplified block diagram of a device including an array of variable resistance cells applied, for example, for neuromorphic memory.

Figures 24-26 illustrates a system including a sum-of-products accelerator array, and various operations thereof.

DETAILED DESCRIPTION

A detailed description of embodiments of the present invention is provided with reference to the Figures 1-26.

Figure 1 is a diagram of a sum-of-products operation, where the terms of the summation are the product of input $X_i$ times a weight $W_i$, in this example, where i goes from 1 to 7. The weight $W_i$ can differ over the terms of the summation. In operation, the weights can be assigned as a set of coefficients, and then the inputs applied to compute a summation that changes as the inputs change. Also, in algorithms executing a learning procedure, the weights can be changed from time to time as the learning procedures change coefficients to learn from the summation that achieves a useable result.

In the illustrated example, the output of the summation is applied to a sigmoid function to produce an output that ranges in a non-linear fashion between a minimum and a maximum such as between 0 and 1. This is a common model of a synapse for example used in neuromorphic computing. Other activation functions can be used as well, such a logit function. The sum-of-products operation can be applied as well in configurations not neuromorphic or not otherwise considered to model neurological systems.

Figure 2 is a schematic diagram of an array of variable resistance cells, where each of the cells in the array comprises a programmable threshold transistor (e.g. 12) and a resistor (*e.g.* 14) connected in parallel. In this illustration, the array includes four strings of variable resistance cells, where each string comprises four variable resistance cells in series between a summing node SUM1 to SUM4, and a reference line, such as ground (*e.g.* 26). Four word lines WL1 to WL4 are coupled to the control terminals of the variable resistance cells in each of the strings. As indicated in the figure, there can be any number of columns and summing nodes up to $SUM_n$, and any number of word lines up to $WL_m$. The variable resistance cells at column n and row m have weights $W_{nm}$ set as a function of the programmable threshold Vt of the cell, the resistance $R_{nm}$ of the resistor in the cell, and the current In in the column.

A voltage applied to the word lines corresponds to the variable inputs $X_l$ to $X_4$, ...$X_m$ In this manner, the variable resistance of each of the variable resistance cells in the strings is a function of a voltage applied on the word line to the control gate of the cell, a threshold of the programmable threshold transistor in the cell, the current in the cell, and the resistor.

The summing nodes ($SUM_1$ to $SUM_4$, ... $SUM_n$) are coupled to a voltage sensing sense amplifier to generate a signal representing the sum-of-products output of each of the strings. A current source 21-24 is coupled to each of the strings to apply a constant current, in a representative example, to each string during the sensing operation.

Figure 3 is a schematic diagram of one variable resistance cell, such as that used in the array of Figure 2. The variable resistance cell includes a first current-carrying node 30, a second current-carrying node 31 and a control terminal 32. A programmable threshold transistor 35 and a resistor 36 are connected in parallel to the first and second current-carrying nodes. The programmable threshold transistor has a gate connected to the control terminal 32.

A voltage $V_G$ on the control terminal 32 can be characterized as a gate voltage for the programmable threshold transistor 35. The control terminal 32 can correspond to a word line in the array shown in Figure 2. A voltage $V_S$ on the first current-carrying node 30 can be characterized as a source voltage for the cell. A voltage $V_D$ on the second current-carrying node 31 can be characterized as a drain voltage for the cell.

In this example, a cell current $I_C$ is applied to the second current-carrying node 31, having a current amplitude that is set in design, or adjustable, to establish a voltage drop in the cells, depending on the voltage range of the voltage sense amplifier, and the resistance values in the cells for the resistor 36. The current amplitude can be tuned according to a particular embodiment of the array, so that a usable range of voltages can be generated on the string for supply to the summing node. Also, the magnitude of resistance of the resistor and the configuration of the programmable threshold transistor can be designed to operate with the selected current level and a specified sensing range.

The programmable threshold transistor 35 can be implemented using a floating gate memory cell, a split gate floating gate memory cell, a dielectric charge trapping memory cell, such as a SONOS device or other types of dielectric charge trapping cells known as for example BE-SONOS and TANOS, and a split gate, dielectric charge trapping memory cell. Other programmable memory cell technologies, such as phase change memory, metal oxide memory, and so on, may be utilized as well.

Also, in embodiments of the technology, the resistor 36 can be implemented as a buried implant resistor between source and drain terminals of the programmable threshold transistor 35.

Figure 4 is a simplified cross-section of a floating gate device having a resistor connected in parallel with its channel, and the resistor being implemented using an ion implantation process which results in a buried implant resistor 110.

In this example, the device is implemented on a substrate 100, which can be a p-type substrate. A source terminal 101 and a drain terminal 102 are implemented by n-type ion implantation in the substrate 100. The source terminal 101 and the drain terminal 102 have contacts 107, 108 formed thereon, coupled to a source node having voltage $V_S$ and a drain node having voltage $V_D$. A p-type channel region 113 is disposed between the buried implant resistor 110 and a gate dielectric layer 105 (tunnel oxide) that overlies the substrate 100 between the source terminal 101 and the drain terminal 102. A floating gate polysilicon layer 103 is disposed over the gate dielectric layer 105. An interpoly dielectric 106 is disposed over the floating gate polysilicon layer 103, implemented in some embodiments using a multilayer structure comprising silicon oxide, silicon nitride, and silicon oxide layers (ONO). A control gate polysilicon layer 104 is disposed over the inter-poly dielectric 106. A contact layer 109 is formed over the control gate polysilicon layer 104. Sidewall structures (not numbered) are formed along the sidewalls of the gate stack.

The structure shown in Figure 4 can be implemented using floating gate cell manufacturing technologies, modified by an additional doping step to form the buried implant resistor 110. The buried implant resistor 110 connects the source terminal 101 and the drain terminal 102 to act as a passive resistor. In this manner, the floating gate device and the buried implant resistor 110 provide a programmable threshold transistor and a resistor connected in parallel between a first current carrying terminal, the source terminal 101, and a second current carrying terminal, the drain terminal 102.

In Figure 4, a current path 112 is illustrated that passes through the buried implant resistor 110 between the source terminal 101 and the drain terminal 102. Also, a current path 114 is illustrated, which is activated when the gate voltage and charge trapped in the floating gate, in combination with a source voltage $V_S$, result in current flow through the channel of the transistor.

Thus, the device has a variable resistance (or variable conductance) that is a function of the resistance of the buried implant resistor 110, and the resistance of the channel of the floating gate device. The resistance of the channel of the floating gate device is a function of the gate voltage, and of the charge trapped in the floating gate.

Figure 5 is a simplified cross-section of a dielectric charge trapping device having a resistor connected in parallel with its channel, and implemented using an ion implantation process which results in a buried implant resistor 210.

In this example, the device is implemented on a substrate 200, which can be a p-type substrate. A source terminal 201 and a drain terminal 202 are implemented by n-type ion implantation in the substrate 200. The source terminal 201 and the drain terminal 202 have contacts 207, 208 formed thereon, coupled to a source node having voltage $V_S$ and a drain node having voltage $V_D$. A p-type channel region 213 is disposed between the buried implant resistor 210 and a tunneling dielectric layer 205 that overlies the substrate 200 between the source terminal 201 and the drain terminal 202. A dielectric charge trapping layer 203 is disposed over the tunneling dielectric layer 205. A blocking dielectric 206 is disposed over the dielectric charge trapping layer 203. A control gate polysilicon layer 204 is disposed over the blocking dielectric 206. A contact layer 209 is formed over the control gate polysilicon layer 204. Sidewall structures (not numbered) are formed along the sidewalls of the gate stack.

The structure shown in Figure 5 can be implemented using dielectric charge trapping memory cell manufacturing technologies, modified by an additional doping step to form the buried implant resistor 210. The buried implant resistor 210 connects the source terminal 201 and the drain terminal 202 to act as a passive resistor. In this manner, the dielectric charge trapping device and the buried implant resistor 210 provide a programmable threshold transistor and a resistor connected in parallel between the source terminal 201 and the drain terminal 202.

In Figure 5, a current path 212 is illustrated that passes through the buried implant resistor 210 between the source terminal 201 and the drain terminal 202. Also, a current path 214 is illustrated, which is activated when the gate voltage and charge trapped in the dielectric charge trapping layer, in combination, result in current flow through the channel of the device.

Thus, the device has a variable resistance (or conductance) that is a function of the resistance of the buried implant resistor 210, and the resistance of the channel of the dielectric charge trapping device. The resistance of the channel of the dielectric charge trapping device is a function of the gate voltage, and of the charge trapped in the dielectric charge trapping gate.

In both of the embodiments of Figure 4 and Figure 5, a cell is illustrated that consists of one transistor and one resistor (1T-1R). Furthermore, the embodiments of Figure 4 and Figure 5 can implement the resistor as a buried implant resistor within the layout footprint of a single variable threshold transistor, in effect making an array of one transistor (IT) cells, for a very compact layout configured for sum-of-products operations with voltage sensing.

In operation, the cells illustrated in Figures 4 and 5 can be characterized as follows.

While the gate-to-source voltage $V_{GS}$ is less than the threshold voltage Vt, current can flow in the buried implant resistor but no transistor channel ("surface channel") is formed, allowing only current $I_B$ in the buried resistor. Thus, the current in the cell is equal to $I_B$ and the resistance of the cell is equal to the drain-to-source voltage $V_{DS}$ divided by the current $I_B$.

While the gate-to-source voltage $V_{GS}$ is greater than the threshold voltage Vt, both the surface channel current Is and the buried resistor current $I_B$ are induced. The channel resistance can be much less than the resistance of the buried resistor, and so Is can dominate when the transistor is on. Thus, the current $I_n$ in the column is divided in the cell so that it is equal to the sum $I_S$+$I_B$, and the cell resistance is equal to the drain-to-source voltage $V_{DS}$ divided by the current $I_n$.

Since the threshold of the floating gate or dielectric charge trapping cell is programmable, this cell resistance can emulate a product of a parameter X(i) represented by the gate voltage, and a parameter W(i) represented by the charge trapped in the cell, the resistance of the resistor in the cell and the cell current. The parameter W(i) can be a binary value, where the cell operates in one of two states ($I_B$ only higher resistance state and $I_B+I_S$ lower resistance state). If the cell is operated in the linear region for FET behavior, then the parameter W(i) can be analog, and vary in range according the charge trapped in the cell.

Figures 6-9 illustrate stages in a manufacturing process that can be used to implement a cell like that of Figure 4. In Figure 6, a substrate 300 is shown after formation of shallow trench isolation structures 301 and 302 that provide dielectric boundaries for a cell. Also, a well implant has been applied to form a p-type well represented by the boundary 303 providing a region in the substrate 300 in which the cells are formed. Different blocks of cells in an array can be implemented in separate blocks, allowing independent biasing of the wells for the separate blocks.

Figure 7 illustrates a stage after a buried channel implant of n-type dopants such as phosphorus and arsenic are applied to form a buried implant resistor 304 between the shallow trench isolation structures 301 and 302.

Figure 8 illustrates a stage after formation of the gate stack structures (floating gate 315, control gate 316, tunneling dielectric and interpoly dielectric along with sidewalls 320) and formation of source and drain regions 310 and 311 using an implant of n-type dopants.

Figure 9 illustrates a stage in the manufacturing after formation of an interlayer dielectric 322 and interlayer contacts 325 and 326. The structures are formed in the illustrated example, using a process that forms silicide contacts on the source and drain regions, followed by a thin dielectric and an etch stop layer 321 over the gate stack and source and drain regions 310 and 311. The interlayer dielectric 322 is deposited, and vias are etched to form openings in which the source and drain contacts 325 and 326 are formed by tungsten deposition or other techniques.

As can be seen, a variable resistance cell such as that shown in Figure 4 is manufactured according to these procedures. These same procedures, can be modified for the purposes of manufacturing a cell such as that shown in Figure 5, by modifying the gate stack including the gate dielectric, the charge trapping layer, the blocking layer and the control gate.

Variable resistance cells having structures like that shown in Figures 4 and 5 can be arranged in series using patterned conductor layers connected to contacts 325, 326.

Figures 10A and 10B are cross-section and layout views of variable resistance cells arranged in series in a NAND-like structure.

Figure 10A shows a simplified cross-section of a substrate in which a series-connected string 400 of variable resistance cells is formed. The gate stacks 410-415, including charge trapping layers (floating gate or dielectric) and word lines, overlie the substrate and extend as elements of word lines in a direction perpendicular to the drawing page. In representative implementations, there may be for example 32 or 64 active word lines. In some embodiments, the series-connected strings may include a smaller number of active word lines or a larger number as suits a particular implementation. In some cases, there may be one or more dummy word lines which can be on opposing ends of the strings as is typical for example in high density NAND flash memory. Dummy word lines can be implemented for manufacturing quality or biasing purposes but not used in the sum-of-products operations of the string.

In this example, the substrate is a p-type substrate, and current carrying terminals (*i.e.* source/drain terminals) of the variable resistance cells are implemented by n-type implants 420-427. In some high density embodiments, implants are not used in current carrying terminals between the cells, so the current carrying terminals rely on inversion for charge carriers as in the channel regions. No contacts are made directly to the current carrying terminals between all the cells in a NAND-like embodiment as illustrated.

String select word lines 401 and 402 are disposed on opposing ends of the series-connected strings. Active regions 504 and 505 comprise n-type implants in the substrate used for bit line and common source line connections for the series-connected strings. The active regions 504 and 505 can be deeper implants or higher conductivity implants then the current carrying terminals of the variable resistance cells. A bit line contact 502 connects the active region 504 to a bit line in an overlying patterned conductor layer. A source line contact 503 connects the active region 505 to a source line in an overlying patterned conductor layer.

An n-type buried implant resistor 451 is implemented, extending in this example from the edge of a channel of a select gate controlled by the bit line side string select word line 401, to the edge of the channel of a select gate controlled by source line side string select line 402. In this manner, the select gates operate to connect and disconnect the buried implant resistor 451 to the active regions 504, 505.

In this example, a p-type guard layer 450, having a higher p-type impurity concentration than the channel regions of the variable resistance cells, is disposed between the channels and the buried implant resistor 451. The p-type guard layer 450 helps to shield the buried implant resistor 451 from the gate voltage, and maintain the stability of the parallel resistance value.

Figure 10B is a plan view diagram of series connected strings of variable resistance cells implemented as shown in Figure 10A. Common reference numerals (401, 402, 410-415) are given to the gate stacks (including word lines) and select lines. Likewise, the common reference numbers 502, 503 are given to bit line and source line contacts.

Figure 10B shows two series connected strings arranged in parallel with bit lines 500, 501, which are implemented in overlying patterned conductor layers above the gate stacks 410-415.

Embodiments of sum-of-products arrays utilizing variable resistance cells can have very large arrays, including arrays having thousands or millions of variable resistance cells. Manufacturing techniques that are utilized for large-scale NAND devices can be applied, with the addition of steps for implementation of the buried implant resistors or other resistor structures, in the manufacturing of large sum-of-products arrays implemented in NAND-like structures as shown in Figures 10A and 10B. Operating techniques for writing (program and erase) weights to the programmable resistance cells can be like those utilized for large-scale NAND devices can be applied. As mentioned above, the programmable resistance cells can be operated in an analog mode. In the analog mode, peripheral circuitry for sensing circuitry and signal routing can be complex.

The peripheral circuitry can be simplified by configuring the programmable resistance cells in the array of cells to operate in a "binary" mode. The programmable threshold transistors can store binary state. The current applied to the columns can be constant, or applied in a fixed number of binary levels. The resistors in the programmable resistance cells can be constant throughout the array, or be implemented in a fixed number of binary levels of resistance.

Binary mode operation can allow simplification of the peripheral circuits, by reducing the complexity of the programming algorithms needed to program the threshold in the cells, the current sources used to apply current to the columns in the array and the sensing circuitry used to generate output values.

Figure 11A shows a circuit schematic of a single programmable resistance cell. Figure 11B provides an IV curve (a current versus voltage plot) by which operation of the cell in a one bit per cell, binary mode can be understood. The cell as current carrying nodes 600 and 601. An input node 602 is connected to the gate of a programmable transistor as discussed above. The resistance of the parallel resistor in the cell is set at a value $R_{mn}$, where m corresponds to the row of the cell, and n corresponds to the column of the cell.

The graph in Figure 11B shows two voltage versus current traces. The first voltage versus current trace corresponds to a "1" cell weight $W_{mn}$ in which the cell has a low threshold Low Vt. The second trace corresponds to a "0" cell weight $W_{mn}$ in which the cell has a high threshold High Vt. When the input value is low, so that the Low Vt is greater than the input voltage, the transistor in the cell is off and conducts very low current for either binary weight of the cell. When the input value is high, so that the Low Vt is less than the input voltage, and the input voltage is less than the High Vt, then the transistor in the cell is on if the weight is "1" corresponding to a Low Vt cell, and the transistor is off if the weight is "0" corresponding to a High Vt cell.

When the transistor is off, a larger voltage drop $V_{dLg}$ dominated by the voltage drop caused by current through the resistor $I*R_{mn}$ is induced. When the transistor is on, a smaller voltage drop $V_{dSm}$ which can be considered to be close to 0 V, dominated by the voltage drop caused by current through the transistor channel, is induced. This relationship is illustrated in the following TABLE 1.

TABLE 1

| **$V_n$ (voltage drop)** | **Weight $W_{mn}$** | |
|---|---|---|
| **Transistor state** | **"0" High Vt (HVt)** | **"1" Low Vt (LVt)** |
| **"1" High : HVt > Input > LVt** | **OFF, (I*R, $V_{dLg}$)** | **ON, (~0, $V_{dSm}$)** |
| **"0" Low: LVt > Input** | **OFF, (I*R, $V_{dLg}$)** | **OFF, (I*R, $V_{dLg}$)** |

The binary operation can be extended to a string of variable resistance cells as illustrated in Figure 12. In Figure 12, three cells are illustrated on a single string in a column n of the array. The column receives a constant current $I_n$ and input values $X_1$ to $X_3$ on respective rows. The voltage drop in the column depends on the weights $W_{1n}$, $W_{2n}$ and $W_{3n}$ of the individual cells in the column, and the input values. This example uses three individual cells to implement three terms $X_iW_i$ for i going from 1 to 3 of a sum-of-products operation, to generate a voltage $V_n$ representing the sum.

With three input variables, shown in the first column, and three potential weights, shown across the second row of the table, and assuming a constant current and constant resistor value for each of the cells, the variations on the voltage drop $V_n$ on the column can be seen (assuming $V_{dSm}$ is close to ("~") zero) in the following TABLE 2.

TABLE 2

| $V_n$ | Weight [$W1_n$ $W2_n$ $W3_n$] | | | | | | | |
|---|---|---|---|---|---|---|---|---|
| Input | [000] | [001] | [010] | [011] | [100] | [101] | [110] | [111] |
| [x1x2 x3] | | | | | | | | |
| [000] | 3 $V_{dLg}$ | 3 $V_{dLg}$ | 3 $V_{dLg}$ | 3 $V_{dLg}$ | 3 $V_{dLg}$ | 3 $V_{dLg}$ | 3 $V_{dLg}$ | 3 $V_{dLg}$ |

(continued)

| [x1x2 x3] | | | | | | | | |
|---|---|---|---|---|---|---|---|---|
| [001] | 3 $V_{dLg}$ | ~ 2 $V_{dLg}$ | 3 $V_{dLg}$ | ~ 2 $V_{dLg}$ | 3 $V_{dLg}$ | ~ 2 $V_{dLg}$ | 3 $V_{dLg}$ | ~ 2$V_{dLg}$ |
| [010] | 3 $V_{dLg}$ | 3 $V_{dLg}$ | ~ 2 $V_{dLg}$ | ~ 2 $V_{dLg}$ | 3 $V_{dLg}$ | 3 $V_{dLg}$ | ~ | ~ 2 $V_{dLg}$ |
| [011] | 3 $V_{dLg}$ | ~2 $V_{dLg}$ | ~ 2 $V_{dLg}$ | ~ $V_{dLg}$ | 3 $V_{dLg}$ | ~ | 2 $V_{dLg}$ | ~ $V_{dLg}$ |
| [100] | 3 $V_{dLg}$ | 3 $V_{dLg}$ | 3 $V_{dLg}$ | 3 $V_{dLg}$ | ~2 $V_{dLg}$ | ~ 2 $V_{dLg}$ | ~ | ~ 2 $V_{dLg}$ |
| [101] | 3 $V_{dLg}$ | ~2 $V_{dLg}$ | 3 $V_{dLg}$ | ~ 2 $V_{dLg}$ | ~ 2 $V_{dLg}$ | ~ $V_{dLg}$ | 2 $V_{dLg}$ | ~ $V_{dLg}$ |
| [110] | 3 $V_{dLg}$ | 3 $V_{dLg}$ | ~ 2 $V_{dLg}$ | ~ 2 $V_{dLg}$ | ~ 2 $V_{dLg}$ | ~ 2 $V_{dLg}$ | ~ $V_{dLg}$ | ~ $V_{dLg}$ |
| [111] | 3 $V_{dLg}$ | ~2 $V_{dLg}$ | ~ 2 $V_{dLg}$ | ~ $V_{dLg}$ | ~ 2 $V_{dLg}$ | ~ $V_{dLg}$ | ~ $V_{dLg}$ | ~0 |

By setting the sensing reference voltages according to these four levels of $V_n$, the voltage across the columns can be translated into numerical outputs between 0 and 3, as shown in the following TABLE 3.

TABLE 3

| Voltage drop (3 - $V_n$ / $V_{dLg}$) | Weight [W1$_n$ W2$_n$ W3$_n$] | | | | | | | |
|---|---|---|---|---|---|---|---|---|
| Input [x1 x2 x3] | [000] | [001] | [010] | [011] | [100] | [101] | [110] | [111] |
| [000] | 0 | 0 | 0 | 0 | 0 | 0 | 0 | 0 |
| [001] | 0 | 1 | 0 | 1 | 0 | 1 | 0 | 1 |
| [010] | 0 | 0 | 1 | 1 | 0 | 0 | 1 | 1 |
| [011] | 0 | 1 | 1 | 2 | 0 | 1 | 1 | 2 |
| [100] | 0 | 0 | 0 | 0 | 1 | 1 | 1 | 1 |
| [101] | 0 | 1 | 0 | 1 | 1 | 2 | 1 | 2 |
| [110] | 0 | 0 | 1 | 1 | 1 | 1 | 2 | 2 |
| [111] | 0 | 1 | 1 | 2 | 1 | 2 | 2 | 3 |

As the number of rows providing unique inputs and number of columns of cells increases, the array can generate complex sum-of-products while relying on "binary" operation (*i.e.*, programming the transistors to a low threshold or a high threshold) of the individual programmable resistance cells.

In some embodiments, multibit binary weights may be stored in some or all of the cells in the array, adding further resolution to programmable weights of the cells.

Figure 13 is a block diagram of sensing circuitry that can be utilized with an array of variable resistance cells configured for sum-of-products operation, with voltage sensing as described above. Sensing circuitry in this example includes a sense amplifier 650 implemented for example using an operational amplifier or other type of comparator. The inputs to the sense amplifier 650 include the voltage $v_n$ and a reference voltage $V_{ref}$ on line 652. The voltage $v_n$ is developed on a selected column, and can be delivered through a buffer 651. The buffer 651 can be implemented for example using a unity gain configured operational amplifier or other voltage to voltage amplifier. The reference voltage $V_{ref}$ on line 652 is provided by a reference voltage circuit 655, which is configured to sequence through a set of reference voltages corresponding to each of the voltage levels to be distinguished by the sense amplifier 650 in response to sequencing signals on line 656. The reference voltage circuit 655 can receive input voltages $V_{max}$ and $V_{min}$ which can determine minimum and maximum voltages to be developed on line 652 as the reference voltage $V_{ref}$.

Figure 13A is a chart that illustrates heuristically the sensing operation. Given voltages $V_{max}$ and $V_{min}$, circuitry of Figure 14 can generate reference voltages at a plurality of levels within a sensing range as indicated by the chart. The voltage $V_n$ developed on a selected column in the array can fall at a level within the sensing range that has a voltage difference above the voltage $V_{min}$. The sensing circuitry determines a level for the voltage $V_n$, which in this case is higher than each of the reference voltages $V_1$ to $V_5$ and lower than the reference voltage $V_6$. It can therefore assign a digital value to the voltage $V_n$ corresponding to the reference voltage $V_6$.

The output of the sense amplifier 650 comprises a sequence of signals that correspond with the input reference voltage level. These signals can be stored in registers 660, that are provided to an arithmetic logic unit 661 or other type of processing circuitry like a digital signal processor, general purpose processor, or the like, where further arithmetic operations can be executed to further the sum-of-products operations. For example, the outputs generated on a plurality of columns of the array can be combined for the purposes of generating a single term of the sum-of-products operation, depending on how the array of programmable resistance cells configured as discussed below.

Figure 14 is a block diagram of a reference voltage circuit which can be utilized with a sense amplifier arrangement like that of Figure 13. In the diagram of Figure 14, a reference column or reference columns 665 in the array of programmable resistance cells, or using cell structures like those used in the array, can be arranged to provide one or both of the voltages $V_{max}$ and $V_{min}$. Voltages $V_{max}$ and $V_{min}$ this example are applied to a resistive voltage divider 666, which produces a plurality of reference voltage levels at nodes between the resistors in the divider 666. The nodes responding to the reference voltage levels are coupled to a selector 667. The selector 667 is responsive to the sequencing signals on line 656 to provide a sequence of reference voltages $V_{ref}$ on line 652, coupled to the sense amplifier 650 in the configuration of Figure 13.

Figure 15 illustrates one configuration of a reference column configured for the purposes of generating voltage $V_{min}$ that can be used as described with reference to Figures 13 and 14 for the purposes of generating the reference voltages used in the sensing circuitry. In the example, a three cell operating string 680 on column n is configured for a sum-of-products operation, where the cells have inputs $X_1$ to $X_3$ and weights $W_{1n}$, $W_{2n}$ and $W_{3n}$. The weights are programmed into the operating string 680 according to the terms of the sum-of-products operation to be executed. The voltage generated by a current In through the string is designated $V_n$.

Reference column 681 is implemented in the array, using three cells that can have electrical characteristics matching those of the three cells used in the operating string 680. In order to generate the voltage $V_{min}$, the weights of the cells in the reference string 681, designated $W_{1ref}$, $W_{2ref}$ and $W_{3ref}$, are all set to the value (in this case "1") of corresponding to the low threshold state. The resistors in the cells of the reference string 681 can have a constant value R that matches the value R in the cells in the operating string 680. The inputs to the cells in the reference string 681 are tied together and coupled to a voltage $V_{ON}$ during operation so that all the cells in the reference string 681 are turned on, and generate the small voltage drop $V_{dSm}$. Thus the voltage $V_{min}$ in this example will be equal to about $3*V_{dSm}$, or three times the small voltage drop of the unit cell used in the operating string 680. TABLE 4 below illustrates an operating example for a given input and weight configuration for the operating string (computation column) and the reference column.

TABLE 4

| Computation column | | | | | Reference column | | Voltage difference for each bit |
|---|---|---|---|---|---|---|---|
| Input | | Weight | | Voltage drop | Input / Weight | Voltage drop | |
| x1 | 1 | $W_{1n}$ | 1 | $\mathbf{V_{dSm}}$ | 1/1 | $\mathbf{V_{dSm}}$ | $\mathbf{V_{dSm} - V_{dSm} - 0}$ |
| x2 | 0 | $W_{2n}$ | 1 | $\mathbf{V_{dLg}}$ | 1/1 | $\mathbf{V_{dSm}}$ | $\mathbf{V_{dLg} - V_{dSm} = V_d}$ |
| x3 | 1 | $W_{3n}$ | 0 | $\mathbf{V_{dLg}}$ | 1/1 | $\mathbf{V_{dSm}}$ | $\mathbf{V_{dLg} - V_{dSm} = V_d}$ |

In an embodiment in which a reference string is used to generate only $V_{min}$, the value $V_{max}$ used by the reference voltage circuitry can be set at a high enough value to provide a good operating margin for the device. The example shown in Figure 15 is based on a string including three variable resistance cells.

In embodiments of the present technology, the variable resistance cells can be implemented in large-scale arrays using NAND -like technologies. Thus, any given column of cells that is coupled in a string can have, for example, 16, 32, 64 or more cells. In the configuration of any given sum-of-products operation, less than all of the cells in a given column may be utilized.

Figure 16 illustrates an example configuration including operating string 690 in operating column n and a reference string 691 in a reference column with a plurality of unused cells in region 692 on the operating and reference columns. The reference column in this example is configured for the purposes of generating voltage $V_{min}$ that can be used as described with reference to Figures 13 and 14 for the purposes of generating the reference voltages used in the sensing circuitry.

In the example shown, a three cell operating string 690 on the operating column n is configured for a sum-of-products operation, where the cells on the operating string 690 have inputs $X_1$ to $X_3$ and weights $W1_n$, $W2_n$ and $W3_n$. The weights are programmed into the operating string 690 according to the terms of the sum-of-products operation to be executed. Unused cells on the operating column n are given inputs $Y_1$ and $Y_2$ and weights $W4_n$ and $W5_n$. The voltage generated by a current In through the string is designated $V_n$. The inputs $Y_1$ and $Y_2$ and weights $W4_n$ and $W5_n$ are configured so that the unused cells in the operating column n are turned on during the sum-of-products operation.

Reference string 691 is implemented in the array or in a reference array, in a reference column using three cells that can have electrical characteristics matching those of the three cells used in the operating string 690. Unused cells on the reference column including the reference string 691 have weights $W4_{ref}$ and $W5_{ref}$. In order to generate the voltage $V_{min}$, the weights of the cells in the reference string 691, designated $W1_{ref}$, $W2_{ref}$ and $W3_{ref}$, and of the cells having weights $W4_{ref}$ and $W5_{ref}$ in the unused part of the column, are all set to the value (in this case "1") of corresponding to the low threshold state. The resistors in the cells of the reference string 691 in the unused part of the column in region 692 can have a constant value R that matches the value R in the cells in the operating string 690 and the value R of the cells in the region 692 in the same column is the operating string 690. The inputs to the cells in the reference string 691 including the unused cells are tied together and coupled to a voltage $V_{ON}$ during operation so that all the cells in the column including the reference string 691 are turned on, and generate the small voltage drop $V_{dSm}$. Thus the voltage $V_{min}$ in this example with five cells in the string, will be equal to about $5^*V_{dSm}$, or five times the small voltage drop of the unit cell used in the operating string 680. With more cells in the string, the value of $V_{min}$ will be shifted accordingly.

TABLE 5 below illustrates an operating example for a given input and weight configuration for the operating string (computation column) and the reference column, for the configuration of Figure 16.

TABLE 5

| Computation column | | | | | Reference column | | Voltage difference for each bit |
|---|---|---|---|---|---|---|---|
| Input | | Weight | | Voltage drop | Input / Weight | Voltage drop | |
| X1 | 1 | $W1_n$ | 1 | $\mathbf{V_{dSm}}$ | 1/1 | $\mathbf{V_{dSm}}$ | $\mathbf{V_{dSm} - V_{dSm} = 0}$ |
| X2 | 0 | $W2_n$ | 1 | $\mathbf{V_{dLg}}$ | 1/1 | $\mathbf{V_{dSm}}$ | $\mathbf{V_{dLg} - V_{dSm} = V_d}$ |
| X3 | 1 | $W3_n$ | 0 | $\mathbf{V_{dLg}}$ | 1/1 | $\mathbf{V_{dSm}}$ | $\mathbf{V_{dLg} - V_{dSm} = V_d}$ |
| Y1 | 1 | $Wy_{1n}$ | 1 | $\mathbf{V_{dSm}}$ | 1/1 | $\mathbf{V_{dSm}}$ | $\mathbf{V_{dSm} - V_{dSm} = 0}$ |
| Y2 | 1 | $Wy_{2n}$ | 1 | $\mathbf{V_{dSm}}$ | 1/1 | $\mathbf{V_{dSm}}$ | $\mathbf{V_{dSm} - V_{dSm} = 0}$ |

Figure 17 illustrates an example configuration in which both the voltages $V_{min}$ and $V_{max}$ are generated. In this configuration, an operating string 700 in an operating column n includes three cells as in the examples of Figure 15 and Figure 16. Thus, the operating column n is configured for a sum-of-products operation, where the cells in the operating string 700 have inputs X1 to X3 and weights $W1_n$, $W2_n$ and $W3_n$. The weights are programmed into the operating string 700 according to the terms of the sum-of-products operation to be executed. Unused cells on the operating column n are given inputs Y1 and Y2 and weights $W4_n$ and $W5_n$. The voltage generated by a current In through the string is designated $V_n$. The inputs Y1 and Y2 and weights $W4_n$ and $W5_n$ are configured so that the unused cells in the operating column n are turned on during the sum-of-products operation.

A $V_{min}$ reference column includes a reference string 701 and unused cells in the region 703 of the array. The reference string 701 includes three cells that can have electrical characteristics matching those of the three cells used in the operating string 700. Unused cells on the $V_{min}$ reference column include the reference string 691 weights $W4_{Lref}$ and $W5_{Lref}$. In order to generate the voltage $V_{min}$, the weights of the cells in the reference string 701, designated $W1_{Lref}$, $W2_{Lref}$ and $W3_{Lref}$, and of the unused cells in the $V_{min}$ column having weights $W4_{Lref}$ and $W5_{Lref}$ in the unused part of the column, are all set to the value (in this case "1") corresponding to the low threshold state. The resistors in the cells of the reference string 701 and in the unused part of the column can have a constant value R that matches the value R in the cells in the operating string 700 and the value R of the cells in the region 703 in the operating column n. The inputs to the cells in the $V_{min}$ reference column including reference string 701 and the unused cells are tied together and coupled to a voltage $V_{ON}$ during operation so that the transistors in all the cells in the $V_{min}$ reference column including the reference string 701 are turned on, and assuming $I_{ref}$ is equal to In, generate the small voltage drop $V_{dSm}$. Thus, the voltage $V_{min}$ in this example with five cells in the string, will be equal to about $5^*V_{dSm}$, or five times the small voltage drop of the unit cell used in the operating string 700. With more cells in the string, the value of $V_{min}$ will be shifted accordingly.

A $V_{max}$ reference column includes a reference string 702 and unused cells in the region 703 of the array. The reference string 702 includes three cells that can have electrical characteristics matching those of the three cells used in the operating string 700. Unused cells on the $V_{max}$ reference column including the reference string 702 have weights $W4_{Href}$ and $W5_{Href}$. In order to generate the voltage $V_{max}$, the weights of the cells in the reference string 702, designated $W1_{Href}$, $W2_{Href}$ and $W3_{Href}$, and of the unused cells in the $V_{min}$ column having weights $W4_{Href}$ and $W5_{Href}$ in the unused part of the $V_{max}$ reference column, are all set to the value (in this case "0") corresponding to the high threshold state. The resistors in the cells of the reference string 701 and in the unused part of the column can have a constant value R that matches the value R in the cells in the operating string 700 and the value R of the cells in the region 703 in the operating column n. The inputs to the cells in the $V_{max}$ reference column including string 702 are tied together and coupled to a voltage $V_{OFF}$ during operation, and the unused cells are coupled to the voltage $V_{ON}$, so that the transistors in three cells in the column including the $V_{max}$ reference string 701 are turned off, and assuming $I_{ref}$ is equal to In, generate the large voltage drop $V_{dLg}$. Thus, the voltage $V_{max}$ in this example with five cells in the string, will be equal to about $3*V_{dLg}$, or three times the large voltage drop of the unit cell used in the operating string 700. With more cells in the string, the value of $V_{max}$ will be shifted accordingly.

TABLE 6 below illustrates an operating example for a given input and weight configuration for the operating string (computation column) and the reference column, for the configuration of Figure 17.

TABLE 6

| Computation column ($V_n$) | | | | | Reference column, Low boundary ($V_{min}$) | | Reference column, High boundary ($V_{max}$) | | Voltage difference for each bit |
|---|---|---|---|---|---|---|---|---|---|
| Input | | Weight | | Voltage drop | Input / Weight | Voltage drop | Input / Weight | Voltage drop | |
| X1 | 1 | $W1_n$ | 1 | $\mathbf{V_{dSm}}$ | 1/1 | $\mathbf{V_{dSm}}$ | 1/0 | $\mathbf{V_{dLg}}$ | $\mathbf{V_{dSm} - V_{dSm} = 0}$ |
| X2 | 0 | $W2_n$ | 1 | $\mathbf{V_{dLg}}$ | 1/1 | $\mathbf{V_{dSm}}$ | 1/0 | $\mathbf{V_{dLg}}$ | $\mathbf{V_{dLg} - V_{dSm} = V_d}$ |
| X3 | 1 | $W3_n$ | 0 | $\mathbf{V_{dLg}}$ | 1/1 | $\mathbf{V_{dSm}}$ | 1/0 | $\mathbf{V_{dLg}}$ | $\mathbf{V_{dLg} - V_{dSm} = V_d}$ |
| Y1 | 1 | $W4_n$ | 1 | $\mathbf{V_{dSm}}$ | 1/1 | $\mathbf{V_{dSm}}$ | 1/1 | $\mathbf{V_{dSm}}$ | $\mathbf{V_{dSm} - V_{dSm} = 0}$ |
| Y2 | 1 | $W5_n$ | 1 | $\mathbf{V_{dSm}}$ | 1/1 | $\mathbf{V_{dSm}}$ | 1/1 | $\mathbf{V_{dSm}}$ | $\mathbf{V_{dSm} - V_{dSm} = 0}$ |

In the embodiments described with reference to Figures 12 and 15-17, the array of programmable resistance cells is configured into functional sets that have one input $X_i$, and include one member cell, each cell in the operating column implementing a term $X_iW_i$ having one bit binary weight $W_i$, that is determined by the threshold of the programmable threshold transistor in the cell. The resistance R of the resistors in the cell, and the current In in the string are constants.

In some embodiments, the array of programmable resistance cells can be configured into functional sets having one input and multiple members to implement a term $X_iW_i$ of the sum-of-products operation in which the weight $W_i$ can be values other than a one bit binary "0" or "1", such as a multiple bit binary value, using a single bit value programmed in the programmable transistors in the cells.

Figures 18-22 illustrate some example configurations of functional sets that implement multiple bit binary values.

Figure 18 illustrates a functional set including three member cells on a single string in a column n of the array. The column receives a constant current In. Input value $X_m$ is connected to the gates of the transistors in the cells in all three rows. In this example, the resistances of the resistors $R_{1,mn}$, $R_{2,mn}$ and $R_{3,mn}$ in the three cells in the set are different. Thus the resistor R3 has a resistance R, the resistor R2 has a resistance 2*R, and the resistor R1 has a resistance 4*R. Thus, the weight of the functional set has a three bit binary value, ranging from 0 to 7, based on combinations making the effective resistance vary from 0*R (all transistors in the functional set on) to 7*R (all transistors in the functional set off). The term of the sum-of-products operation implemented using the functional set of Figure 18 can be characterized as $X_m$(W1*4R + W2*2R + W3*R). In other embodiments, a function set of cells in the array like that of Figure 18 can have more than three members connected in a column with a common input $X_m$.

An array of cells as discussed above can be configured using logic circuits to implement terms of a sum-of-products operation using many functional sets configured to implement many forms of the terms of the operation.

Figure 19 illustrates a functional set including three member cells in one row of the array on three different columns n1, n2 and n3 of the array. Each of the three columns receives a constant current In. Input value $X_m$ is connected to the gates of the transistors in the cells in the row. In this example, the resistances of the resistors $R_{1mn}$, $R_{2,mn}$ and $R_{3,mn}$ in the three cells in the set are different. Thus the resistor R3 has a resistance R, the resistor R2 has a resistance 2*R, and the resistor R1 has a resistance 4*R. The voltage generated in each of the column $V_{n1}$, $V_{n2}$ and $V_{n3}$ are summed in peripheral circuitry to provide the sum output of the term.

The term of the sum-of-products operation implemented using the functional set of Figure 19 can be characterized as $X_m$(W1*I4R + W2*I2R + W3*IR), with each column producing a voltage representing one part of the term. Thus, the weight of the functional set has a three bit binary value, ranging from 0 to 7, based on combinations making the voltage vary from 0*IR (all transistors in the functional set on) to 7*IR (all transistors in the functional set off).

Peripheral circuitry configured to perform the sum can include analog summing amplifiers or digital logic. In one example, the voltage on each column can be sensed in sequence, and the results of each sensing step added in arithmetic logic as illustrated in Figure 13 for example.

In other embodiments, a function set of cells in the array like that of Figure 19 can have more than three members connected in a column with a common input $X_m$.

Figure 20 illustrates a functional set including three member cells in one row of the array on three different columns n1, n2 and n3 of the array. Input value $X_m$ is connected to the gates of the transistors in the cells in the row. In this example, the resistances of the resistors $R_{1,mn}$, $R_{2,mn}$ and $R_{3,mn}$ in the three cells in the set are the same. Each of the three columns receives a different constant current $I_n$. Thus a current source provides $I_3$ to column 3 with a current I, a current source provides $I_2$ to column 2 with a current 2*I, and a current source provides $I_1$ to column 1 with a current 4*I. The voltages $V_{n1}$ $V_{n2}$ and $V_{n3}$ generated in the columns of the functional set are summed in peripheral circuitry to provide the sum output of the term. Thus, the weight of the functional set has a three bit binary value, ranging from 0 to 7, based on combinations making the output values vary from 0*IR (all transistors in the functional set on) to 7*IR (all transistors in the functional set off).

The term of the sum-of-products operation implemented using the functional set of Figure 19 can be characterized as $X_m$(W1*4IR + W2*2IR + W3*IR), with each column producing a voltage representing one part of the term.

Peripheral circuitry configured to perform the sum can include analog summing amplifiers or digital logic. In one example, the voltage on each column can be sensed in sequence, and the results of each sensing step added in arithmetic logic as illustrated in Figure 13 for example.

In other embodiments, a function set of cells in the array like that of Figure 20 can have more than three members connected in a column with a common input $X_m$.

Figure 21 illustrates a functional set including three member cells in one row of the array on three different columns n1, n2 and n3 of the array. Input value $X_m$ is connected to the gates of the transistors in the cells in the row. In this example, the resistances of the resistors $R_{1,mn}$, $R_{2,mn}$ and $R_{3,mn}$ in the three cells in the set are the same. Each of the three columns receives a same constant current $I_n$. The voltages $V_{n1}$, $V_{n2}$ and $V_{n3}$ generated in the columns of the functional set divided by 4, 2 and 1, respectively, and then summed in peripheral circuitry to provide the sum output of the term. Thus, the weight of the functional set has a three bit binary value, ranging from 0 to 7, based on combinations making the output values vary from 0*IR (all transistors in the functional set on) to 7*IR (all transistors in the functional set off).

The term of the sum-of-products operation implemented using the functional set of Figure 21 can be characterized as $X_m$(W1*4IR + W2*2IR + W3*IR), with each column producing a voltage that is divided in peripheral circuit to represent one part of the term.

Peripheral circuitry configured to perform the sum can include analog summing amplifiers or digital logic. In one example, the voltage on each column can be sensed in sequence, and the results of each sensing step added in arithmetic logic as illustrated in Figure 13 for example.

In other embodiments, a function set of cells in the array like that of Figure 21 can have more than three members connected in a column with a common input $X_m$.

Figure 22 illustrates a functional set including four member cells, including two cells in one row of the array and two cells in a second row of the array, on two different columns n1 and n2 of the array. Input value $X_m$ is connected to the gates of the transistors in all cells in both rows of the functional set. In this example, the resistances of the resistors $R_{1,mn}$, $R_{2,mn}$, $R_{3,mn}$ and $R_{4,mn}$ in the four cells in the set are different. Thus the resistors R3 and R4 have resistance R, the resistors R1 and R2 have resistance 4*R. Each of the two columns receives a different constant current In. Thus, a current source provides $I_2$ to column 2 with a current I, a current source provides $I_1$ to column 1 with a current 2*I. The voltages $V_{n1}$ and $V_{n2}$ generated in the two columns of the functional set are summed in peripheral circuitry to provide the sum output of the term.

The term of the sum-of-products operation implemented using the functional set of Figure 22 can be characterized as $X_m$(W1*2I*4R + W2*I*4R + W3*2I*R + W3*I*R), with each column producing a voltage representing one part of the term. Thus, the weight of the functional set has a four bit binary value, ranging from 0 to 15, based on combinations making the output values vary from 0*IR (all transistors in the functional set on) to 15*IR (all transistors in the functional set off).

Peripheral circuitry configured to perform the sum can include analog summing amplifiers or digital logic. In one example, the voltage on each column can be sensed in sequence, and the results of each sensing step added in arithmetic logic as illustrated in Figure 13 for example.

In other embodiments, a function set of cells in the array like that of Figure 22 can have more than three members connected in a column with a common input $X_m$.

Other functional set configurations can be utilized as well.

A large array of programmable resistance cells can be configured between operations to perform complex sum-of-products operations with various functions for the terms of the summation, as needed for each computation executed. Also, the coefficients (*i.e.* weights) of the terms of the summation can set in nonvolatile form in the transistors in the cells, and changed by programming and erasing operations as needed for each computation executed.

Figure 23 is a simplified chip block diagram of an integrated circuit 901 including a sum-of-products array with voltage sensing, and buried channel cells such as illustrated in Figures 5 and 6 and Figure 10A/10B, configured as a neuromorphic memory array 960.

A word line driver 940 is coupled to a plurality of word lines 945. The driver comprises, for example, digital-to-analog converters in some embodiments that produce an input variable x(i) for each selected word line, or in the alternative a binary word line driver can be apply binary inputs. A column decoder 970 is coupled via lines 965 to one or more layers of strings of series-connected cells arranged along columns in the array 960 for selecting strings for reading sum-of-products data from and writing parameter data to the memory array 960. Addresses are supplied on bus 930 from control logic (controller) 910 to decoder 970 and driver 940. Voltage sensing sense amplifiers are coupled to the column decoder via lines 975, and are in turn coupled to buffer circuits 980. Current sources applying the load currents $I_n$ are coupled with the sensing circuits. A program buffer can be included with the sense amplifiers in circuits 980 to store program data for two-level or multiple-level programming of the programmable threshold transistors in the cells. Also, the control logic 910 can include circuits for selectively applying program and inhibit voltages to the strings in the memory in response to the program data values in the program buffer.

Sensed data from the sense amplifiers are supplied via second data lines 985 to data buffer 990, which is in turn coupled to input/output circuits 991 via a data path 993. The sense amplifiers can comprise operational amplifiers configured to apply unity gain or a desired gain level, and provide analog outputs to digital-to-analog converters or other signal processing or signal routing circuits. Additional arithmetic units and routing circuits can be included to provide for arrangement of multiple layers of strings of cells into neuromorphic circuits.

Also, arithmetic units and routing circuits can be included to provide for arrangement of the layers of strings into matrix multiplication units.

Input/output circuits 991 drive the data to destinations external to the integrated circuit 901. Input/output data and control signals are moved via data bus 905 between the input/output circuits 991, the control logic 910 and input/output ports on the integrated circuit 901 or other data sources internal or external to the integrated circuit 901, such as a general purpose processor or special purpose application circuitry, or a combination of modules providing system-on-a-chip functionality supported by the memory array 960.

In the example shown in Figure 23, control logic 910, using a bias arrangement state machine, controls the application of supply voltages generated or provided through the voltage supply or supplies in block 920, for sum-of-products read operations, and parameter writing operations to set parameters, such as cell weights, represented by charge trapping levels including, for charge trapping cells and floating gate cells, erase, verify and program bias voltages. The control logic 910 is coupled to the buffer 990 and the memory array 960.

The control logic 910 can be implemented using special-purpose logic circuitry as known in the art. In alternative embodiments, the control logic comprises a general-purpose processor, which can be implemented on the same integrated circuit, which executes a computer program to control the operations of the device. In yet other embodiments, a combination of special-purpose logic circuitry and a general-purpose processor can be utilized for implementation of the control logic.

Figures 24-26 illustrates a configuration of system 1000 including a memory array 1002 and a sum-of-products accelerator array 1001 interconnected using a data path controller 1003. The sum-of-products accelerator array 1001 comprises an array of programmable resistance cells according to any of the embodiments described above. The memory array can comprise a NAND flash array, an SRAM array, a DRAM array, a NOR flash array, or other type of memory that can be used in coordination with the sum-of-products accelerator array 1001.

The system can receive input/output data from outside the system as shown in Figure 24, and route the data to the memory array. The data can include configuration data used to configure the functional sets of cells that implement the terms of one or more sum-of-products operations, weights for the functional sets in the array used for the operations, and input values for the sum-of-products operations.

As represented in Figure 25, data from the memory array 1002 can be transferred to the sum-of-products accelerator array 1001, using a direct data path that can be controlled using the data path controller 1003. Alternatively, a data path through the data path controller 1003 can be used to transfer data from the memory array 1002 to the sum-of-products accelerator array 1001, as suits a particular implementation..

As represented in Figure 26, output data from the sum-of-products accelerator array can be applied through the data path controller 1003 to the input output data paths for the system 1000. The input output data paths for the system 1000 can be coupled to a processing unit configured to compute weights, provide inputs and utilize the outputs of the sum-of-products accelerator array.

Also, the output data from the sum-of-products accelerator array 1001 can be routed through the data path controller 1003 back to the memory array 1002 for use in iterative sum-of-products operations.

The system 1000 including the memory, the sum-of-products accelerator array and the data path logic can be implemented on a single integrated circuit in some embodiments. Also, the system 1000 can include on the same or different integrated circuits, arithmetic logic units, digital signal processors, general-purpose CPUs, state machines and the like that are configured to take advantage of the sum-of-products accelerator array 1001 during execution of computer processes.

A method for using an array of programmable resistance cells according to any of the embodiments described herein can be executed using a system like that of Figures 24-26, using logic implemented on the same integrated circuit, coupled to the integrated circuit, or a combination of both which performs a configuration step in which the functional sets of cells in the array are programmed with respective weights, and an operating step, and which the array is used to produce the sum of products data.

A method for operating an array of variable resistance cells to produce sum of products data comprises programming the programmable threshold transistors in the array with thresholds corresponding to values of a weight factor for the corresponding cell; selectively applying inputs to rows of cells in the array applying currents to corresponding ones of the columns of cells in the array; and sensing voltages on one or more of the columns of cells in the array.

Such a method can include configuring cells in the array into functional sets of cells including one or more members; where the functional set implementing respective terms of a sum of products function. Each functional set can receive a corresponding input term and can be programmed with a weight that is a function of the programmable thresholds of the one or more members of the functional set. The functional set can be configured in a variety of ways, such as described above with reference to Figures 18-22. In this way, programmable resistance cells in the array which are operated with weights configured using a one bit binary mode as individual cells, can be configured into functional sets that have multibit weights. The multibit weights can be configured using functional sets of cells that have respective resistors with different resistances, using different current levels during sensing on different columns in the functional set, using arithmetic logic to combine voltages sensed on respective columns in the functional set with different weights, and otherwise as described herein.

Also, in some embodiments, the system can be operated to use a reference column of cells to generate a column reference voltage, or a low column reference voltage and a high column reference voltage as suits a particular implementation. The method can include generating sensing reference voltages as a function of the one or more column reference voltages. The sensing operation can include comparing voltages on selected columns of cells with the sensing reference voltages to generate outputs indicating voltage levels on the selected columns.

While the present invention is disclosed by reference to the preferred embodiments and examples detailed above, it is to be understood that these examples are intended in an illustrative rather than in a limiting sense. It is contemplated that modifications and combinations will readily occur to those skilled in the art.

## Claims

1. A device, comprising an array of variable resistance cells, variable resistance cells in the array each comprising a programmable threshold transistor (12; 35) and a resistor (14; 36) connected in parallel.

2. The device of claim 1, wherein the array includes a plurality of strings of series-connected variable resistance cells.

3. The device of claim 2, including a plurality of word lines (WL1 to WLm; 945) coupled to the strings of series-connected variable resistance cells, and word line drivers (940) connected to the plurality of word lines (WL1 to WLm; 945) and configured to apply variable gate voltages to the programmable threshold transistors (12; 35) in the variable resistance cells.

4. The device of any of the preceding claims, wherein the programmable threshold transistor (12; 35) in the variable resistance cell comprises a charge trapping memory transistor.

5. The device of claim 4, wherein the resistor (14; 36) in the variable resistance cell comprises a buried implant resistor in the charge trapping memory transistor.

6. The device of any of the preceding claims, wherein the programmable threshold transistor (12; 35) in the variable resistance cell comprises a floating gate charge trapping memory transistor, and the resistor (14; 36) in the variable resistance cell comprises a buried implant resistor in the floating gate charge trapping memory transistor; or, wherein the programmable threshold transistor (12; 35) in the variable resistance cell comprises a dielectric charge trapping memory transistor, and the resistor (14; 36) in the variable resistance cell comprises a buried implant resistor in the dielectric charge trapping memory transistor.

7. The device of any of the preceding claims, including a sense amplifier (650) configured for connection to the array of variable resistance cells, which is configured to be responsive to a voltage generated by an applied current and a sum of the variable resistances of a plurality of variable resistance cells in the array.

8. The device of any of the preceding claims, wherein variable resistance cells in the array consist of one transistor having a layout footprint, and one resistor, in which the resistor is implemented within the layout footprint of the one transistor.

**9.** The device of claim 2, further comprising:

variable resistance cells in strings in the plurality of strings each having a first current-carrying node (30), a second current-carrying node (31), and a control terminal (32), and comprising a programmable threshold transistor (35) and a resistor (36) connected in parallel to the first and second current-carrying nodes (30, 31), the programmable threshold transistor (35) having a gate connected to the control terminal (32); and wherein:

a variable resistance of each variable resistance cell in the strings is a function of a voltage applied to the control gate of the cell, a threshold of the programmable threshold transistor (35), and the resistor (36).

**10.** The device of claim 9, including:

a plurality of word lines (WL1 to WLm; 945) coupled to the control terminals (32) of variable resistance cells in the plurality of strings; and
word line drivers (940) connected to the plurality of word lines (WL1 to WLm; 945) and configured to apply variable gate voltages to the word lines (WL1 to WLm; 945).

**11.** The device of any of claims 9 and 10, wherein the programmable threshold transistor (35) in each of the variable resistance cells comprises a charge trapping memory transistor, and the threshold of the transistor (35) is a function of charge trapped in the charge trapping memory transistor.

**12.** The device of claim 11, wherein the resistor (36) in each of the variable resistance cells comprises a buried implant resistor in the charge trapping memory transistor.

**13.** The device of claim 11, including circuitry configured to program the threshold of the charge trapping memory transistor with multiple levels.

**14.** The device of any of claims 9 to 13, wherein the programmable threshold transistor (35) in the variable resistance cell comprises a floating gate charge trapping memory transistor, and the resistor (36) in each of the variable resistance cells comprises a buried implant resistor in the floating gate charge trapping memory transistor, and the threshold of the transistor (35) is a function of charge trapped in the floating gate charge trapping memory transistor; or, wherein the programmable threshold transistor (35) in the variable resistance cell comprises a dielectric charge trapping memory transistor, and the resistor (36) in each of the variable resistance cells comprises a buried implant resistor in the dielectric charge trapping memory transistor, and the threshold of the transistor (35) is a function of charge trapped in the dielectric charge trapping memory transistor.

**15.** The device of any of claims 9 to 14, including a sense amplifier (650) configured for connection to a selected string in the plurality of strings of variable resistance cells, which is configured to be responsive to a voltage generated by an applied current and a sum of the variable resistances of a plurality of variable resistance cells in the selected string; and/or,
wherein variable resistance cells in the plurality of strings consist of one transistor having a layout footprint, and one resistor, in which the resistor is implemented within the layout footprint of the one transistor.

**Amended claims in accordance with Rule 137(2) EPC.**

**1.** A device, comprising an array of variable resistance cells, variable resistance cells in the array each comprising a programmable threshold transistor (12; 35) and a resistor (14; 36) connected in parallel,
**characterized in that**
the resistor (14; 36) comprises a buried implant resistor (110, 210, 304, 451) between source and drain terminals of the programmable threshold transistor (12; 35).

**2.** The device of claim 1, wherein the array includes a plurality of strings of series-connected variable resistance cells.

**3.** The device of claim 2, including a plurality of word lines (WL1 to WLm; 945) coupled to the strings of series-connected variable resistance cells, and word line drivers (940) connected to the plurality of word lines (WL1 to WLm; 945) and configured to apply variable gate voltages to the programmable threshold transistors (12; 35) in the variable resistance cells.

**4.** The device of any of the preceding claims, wherein the programmable threshold transistor (12; 35) in the variable resistance cell comprises a charge trapping memory transistor.

**5.** The device of any of the preceding claims, wherein the programmable threshold transistor (12; 35) in the variable resistance cell comprises a floating gate charge trapping memory transistor; or,
wherein the programmable threshold transistor (12; 35) in the variable resistance cell comprises a dielectric charge trapping memory transistor.

**6.** The device of any of the preceding claims, including a sense amplifier (650) configured for connection to the array of variable resistance cells, which is configured to be responsive to a voltage generated by an applied current and a sum of the variable resistances of a plurality of variable resistance cells in the array.

**7.** The device of any of the preceding claims, wherein variable resistance cells in the array consist of one transistor having a layout footprint, and one resistor, in which the resistor is implemented within the layout footprint of the one transistor.

**8.** The device of claim 2, further comprising:
variable resistance cells in strings in the plurality of strings each having a first current-carrying node (30), a second current-carrying node (31), and a control terminal (32), and comprising a programmable threshold transistor (35) and a resistor (36) connected in parallel to the first and second current-carrying nodes (30, 31), the programmable threshold transistor (35) having a gate connected to the control terminal (32); and wherein:
a variable resistance of each variable resistance cell in the strings is a function of a voltage applied to the control gate of the cell, a threshold of the programmable threshold transistor (35), and the resistor (36).

**9.** The device of claim 8, including:

a plurality of word lines (WL1 to WLm; 945) coupled to the control terminals (32) of variable resistance cells in the plurality of strings; and
word line drivers (940) connected to the plurality of word lines (WL1 to WLm; 945) and configured to apply variable gate voltages to the word lines (WL1 to WLm; 945).

**10.** The device of claim 8 or 9, wherein the programmable threshold transistor (35) in each of the variable resistance cells comprises a charge trapping memory transistor, and the threshold of the transistor (35) is a function of charge trapped in the charge trapping memory transistor.

**11.** The device of claim 10, including circuitry configured to program the threshold of the charge trapping memory transistor with multiple levels.

**12.** The device of any of claims 8 to 11, wherein the programmable threshold transistor (35) in the variable resistance cell comprises a floating gate charge trapping memory transistor, and the threshold of the transistor (35) is a function of charge trapped in the floating gate charge trapping memory transistor; or,
wherein the programmable threshold transistor (35) in the variable resistance cell comprises a dielectric charge trapping memory transistor, and the threshold of the transistor (35) is a function of charge trapped in the dielectric charge trapping memory transistor.

**13.** The device of any of claims 8 to 12, including a sense amplifier (650) configured for connection to a selected string in the plurality of strings of variable resistance cells, which is configured to be responsive to a voltage generated by an applied current and a sum of the variable resistances of a plurality of variable resistance cells in the selected string; and/or,
wherein variable resistance cells in the plurality of strings consist of one transistor having a layout footprint, and one resistor, in which the resistor is implemented within the layout footprint of the one transistor.

**14.** The device of any of the preceding claims, wherein:

the array of variable resistance cells is formed in a p-type substrate and the buried implant resistor is an n-type buried implant resistor (451); and
the variable resistance cells each further comprise a p-type guard layer (450) between a channel region and the n-type buried implant resistor (451), wherein the p-type guard layer (450) has a higher p-type impurity concentration than the channel region.

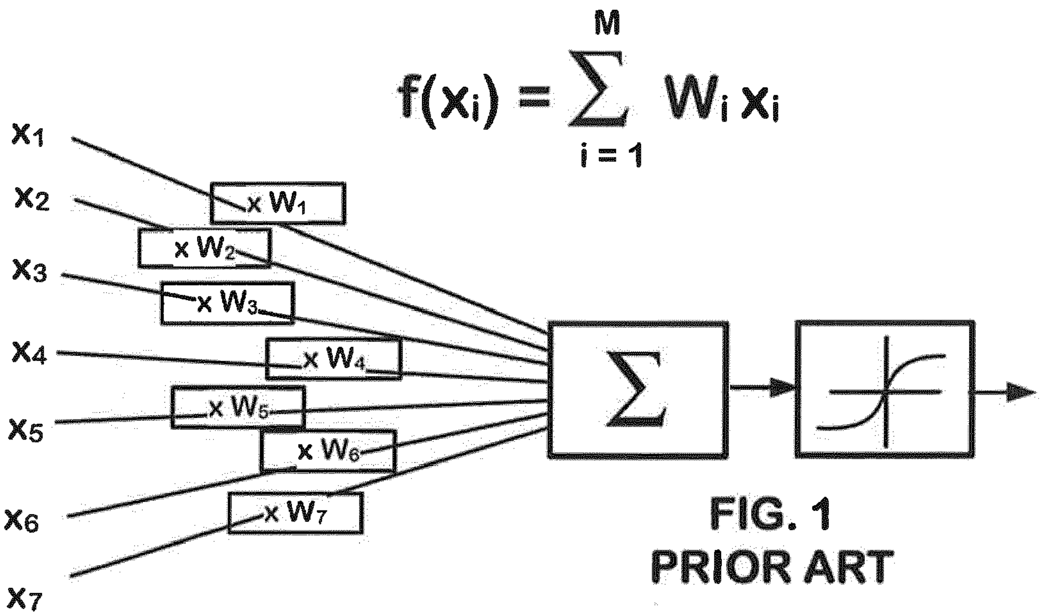


FIG. 1
PRIOR ART

FIG. 2

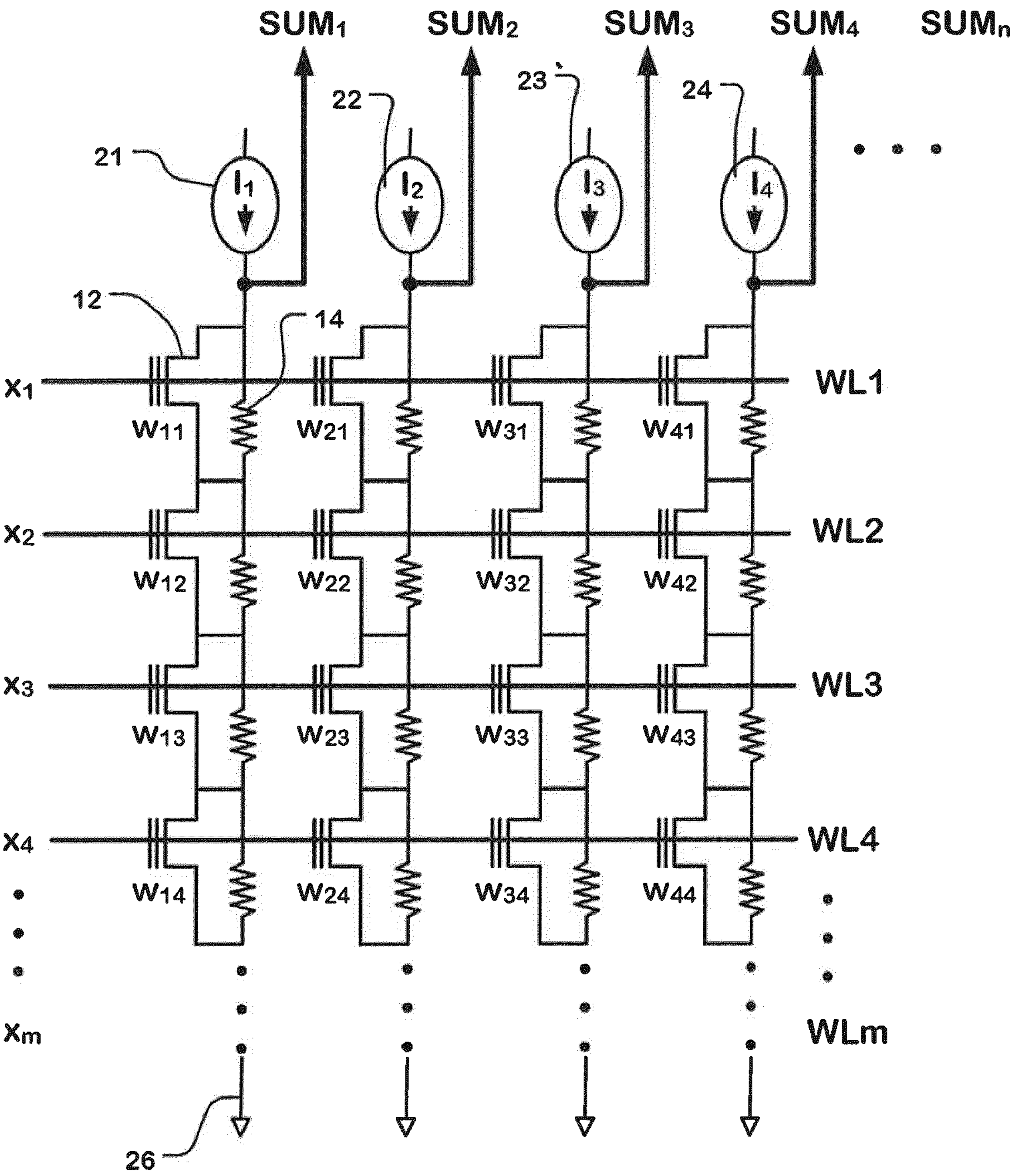
SUM1
SUM2
SUM3
SUM4
SUMn
21
22
23
24
I1
I2
I3
I4
12
14
x1
x2
x3
x4
xm
W11
W21
W31
W41
W12
W22
W32
W42
W13
W23
W33
W43
W14
W24
W34
W44
WL1
WL2
WL3
WL4
WLm
26

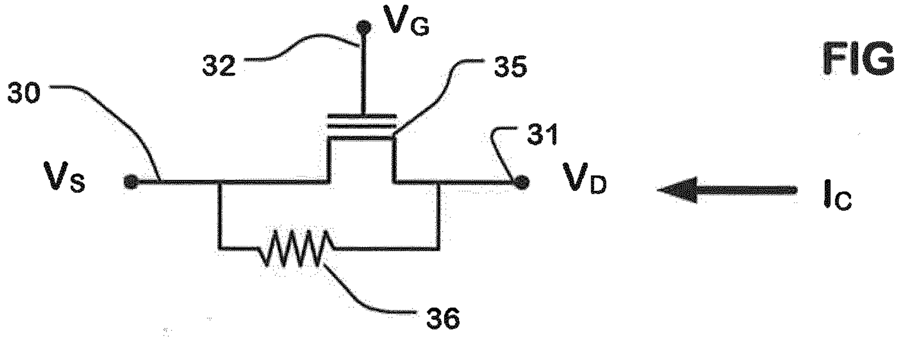


FIG. 3

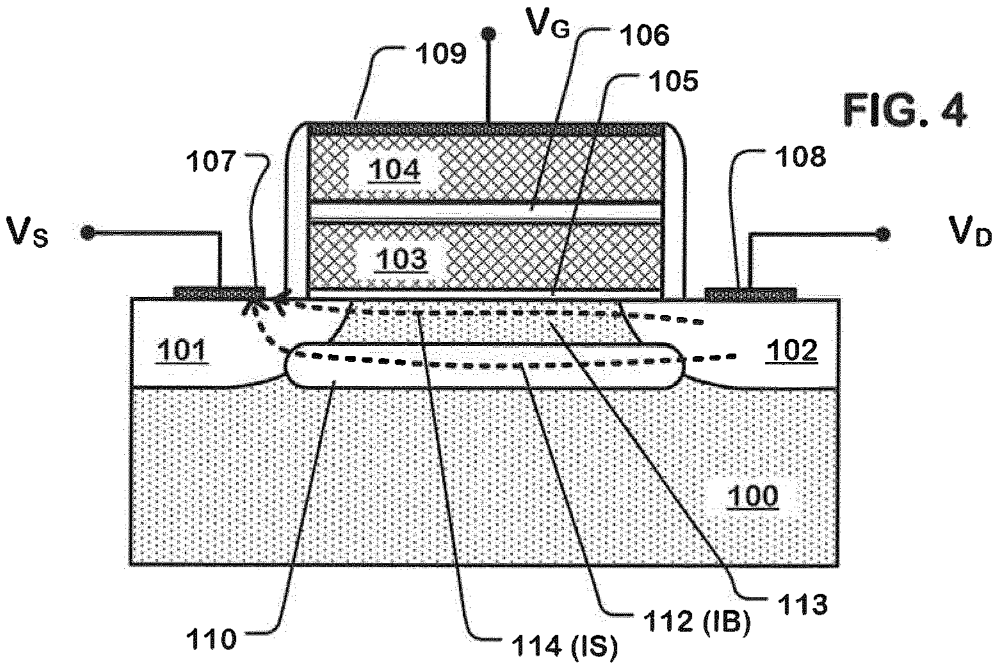


FIG. 4

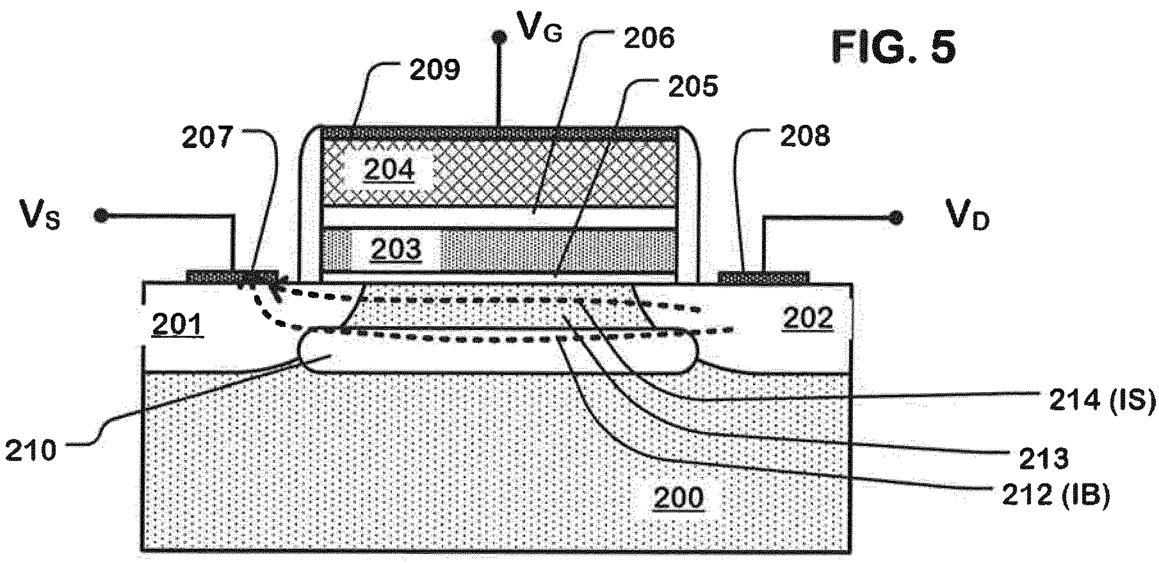


FIG. 5

FIG. 6

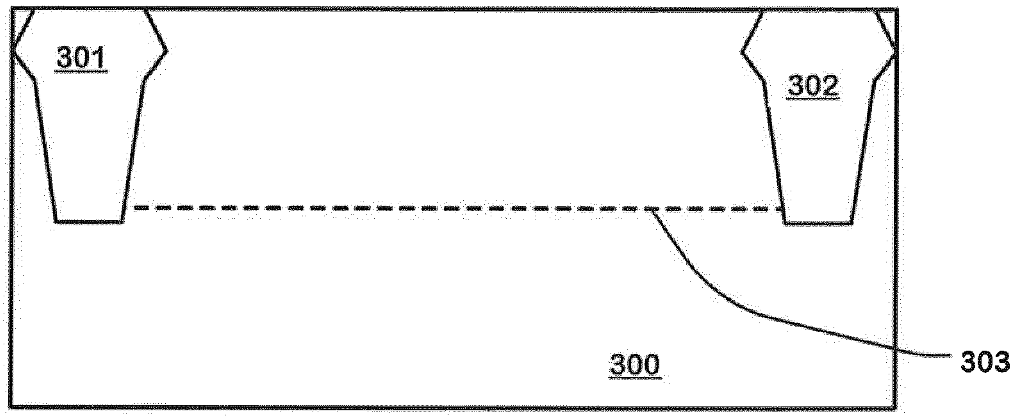


FIG. 7

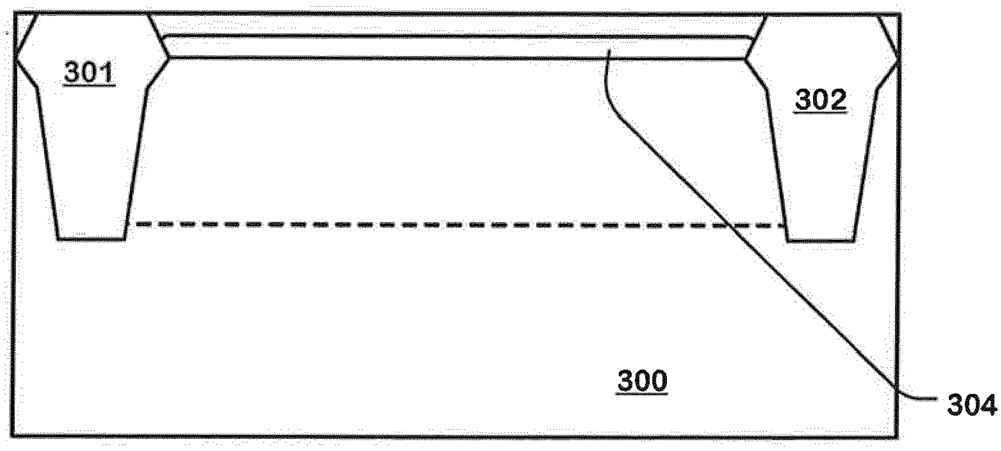

FIG. 8

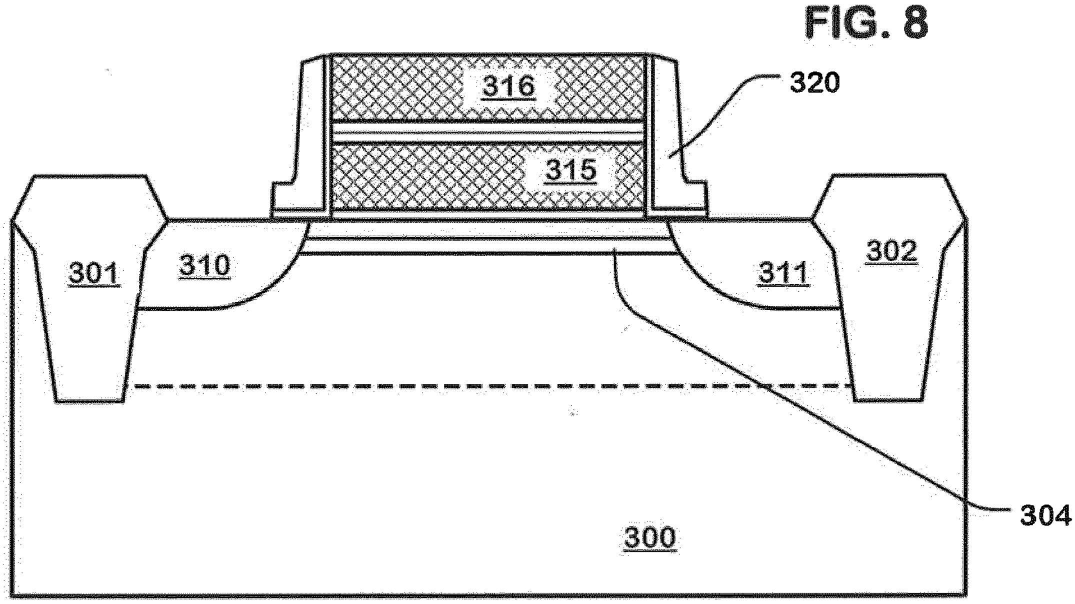
316
320
315
301
310
311
302
304
300

FIG. 9

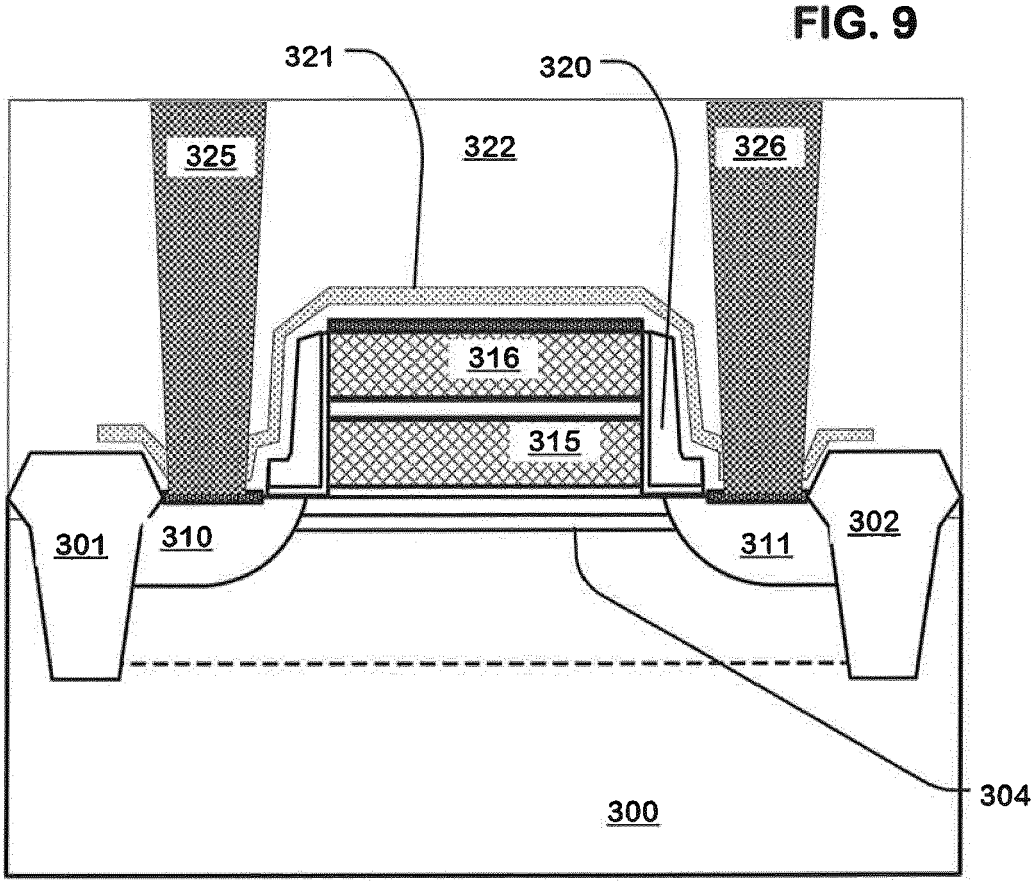
321
320
325
322
326
316
315
301
310
311
302
304
300

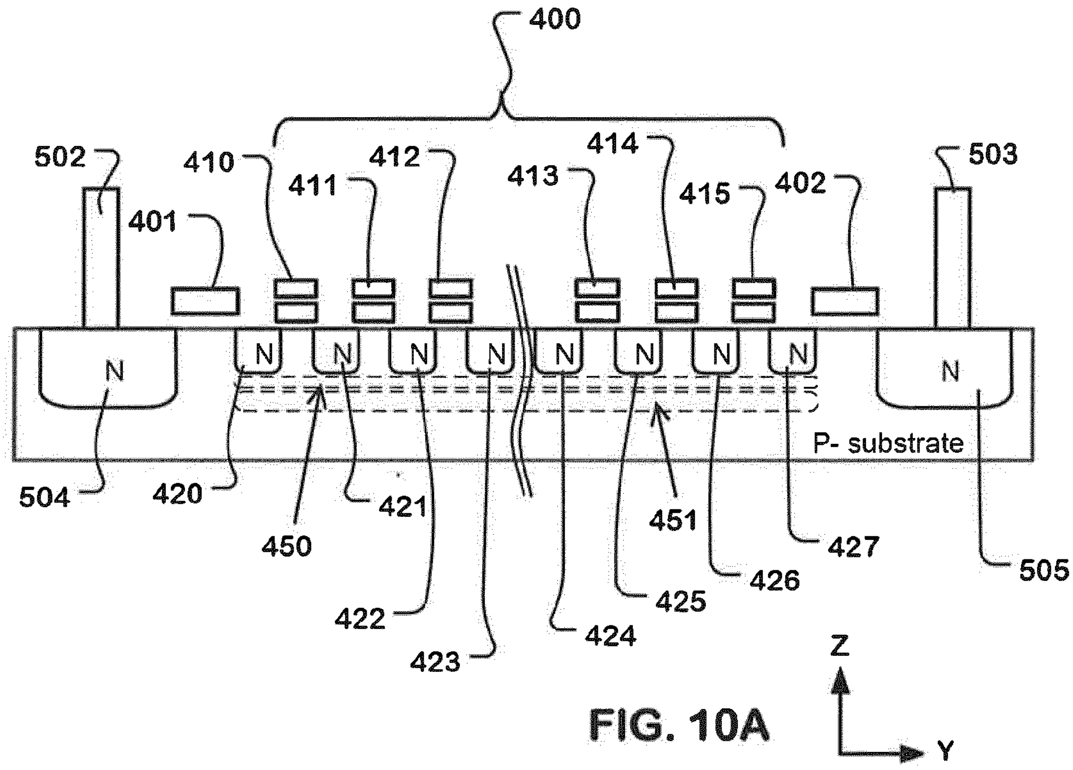


FIG. 10A

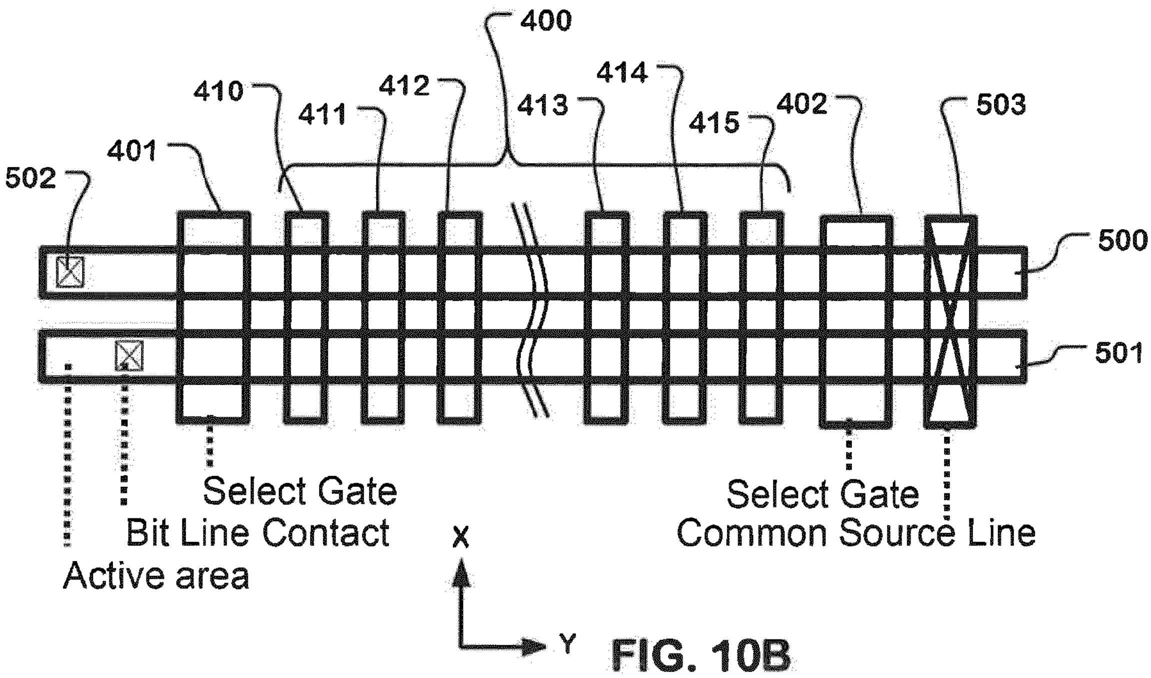


FIG. 10B

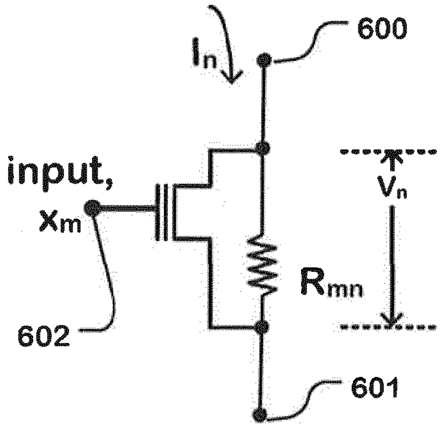


FIG. 11A

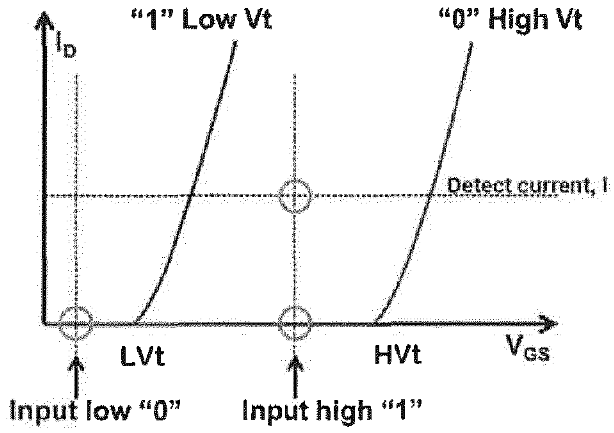


FIG. 11B

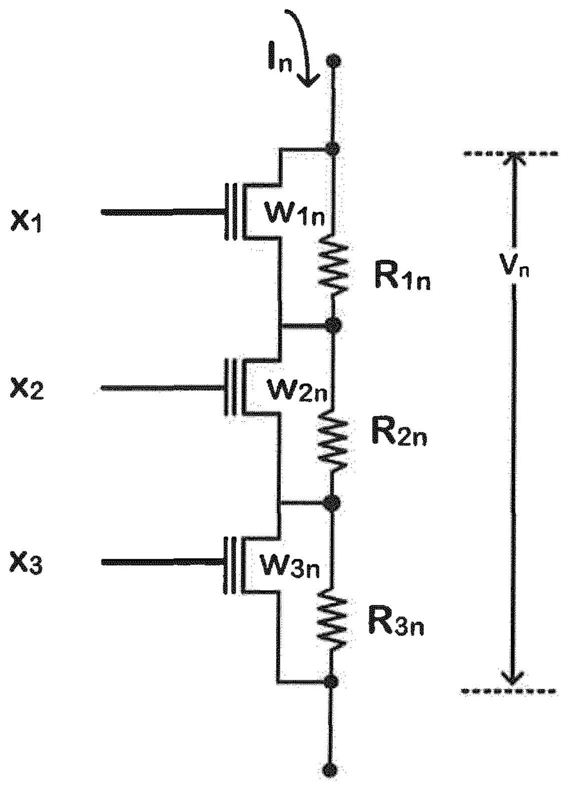


FIG. 12

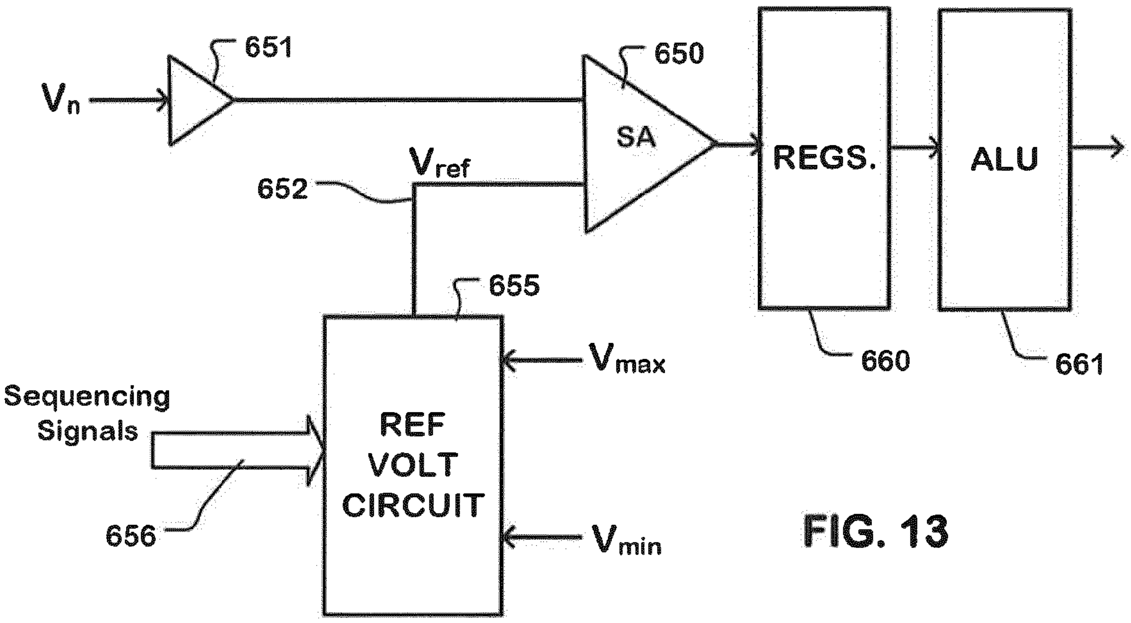


FIG. 13

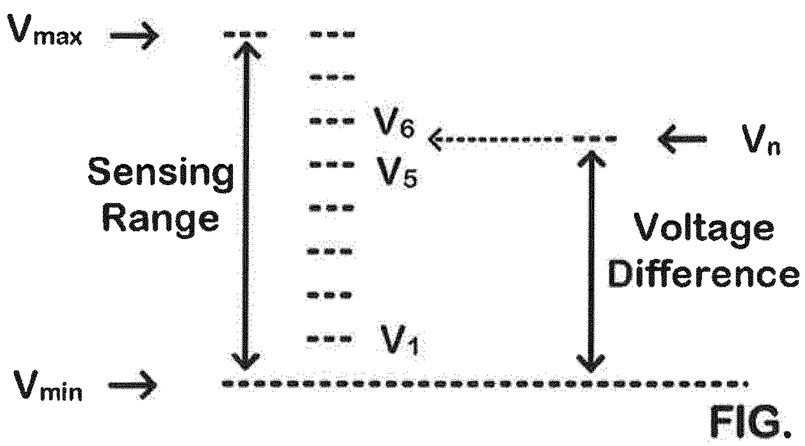


FIG. 13A

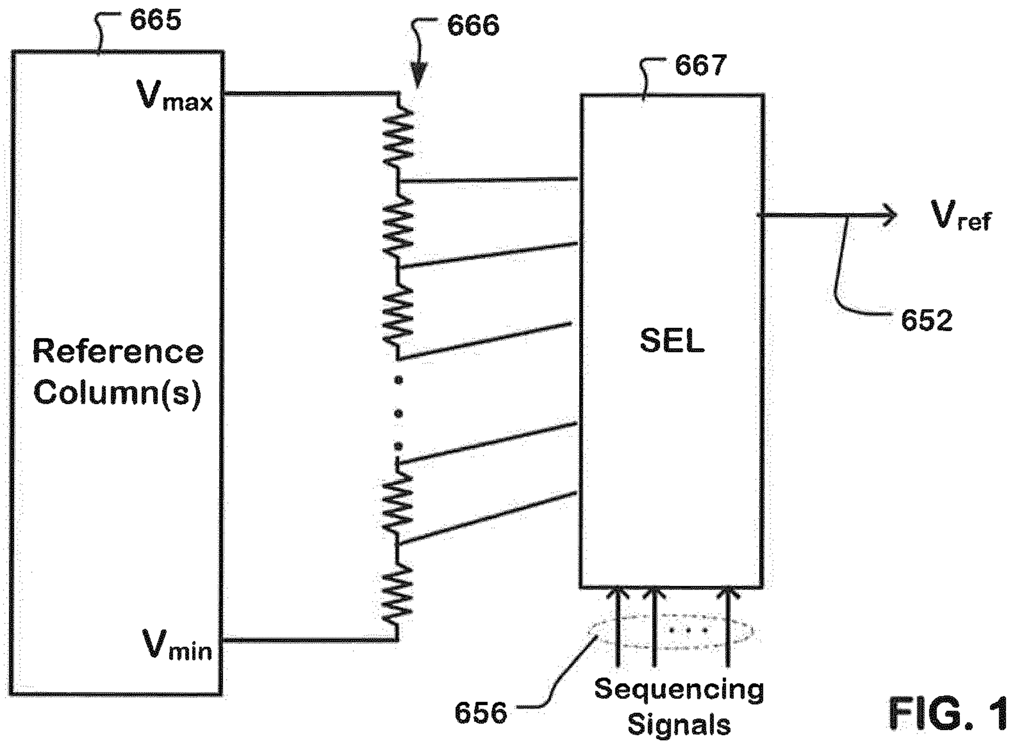
665
666
667
Vmax
Reference Column(s)
Vmin
SEL
Vref
652
656
Sequencing Signals

FIG. 14

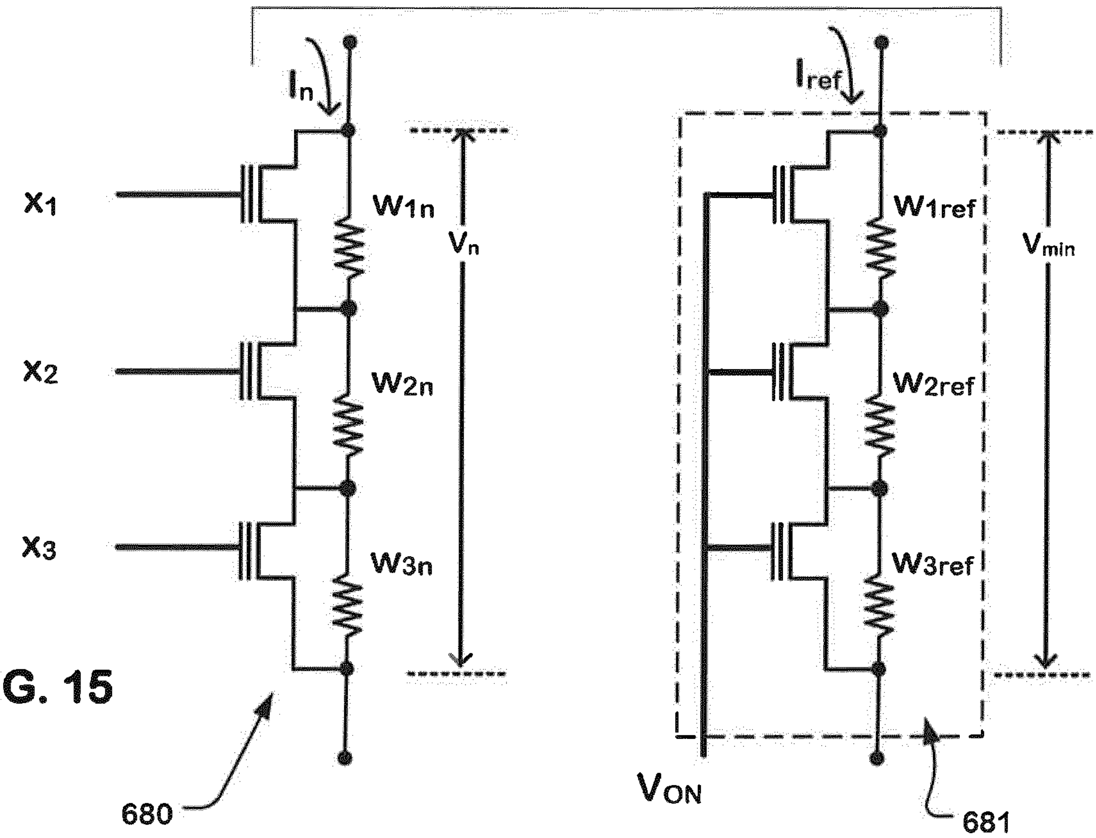
In
Iref
X1
X2
X3
W1n
W2n
W3n
Vn
W1ref
W2ref
W3ref
Vmin
VON
680
681

FIG. 15

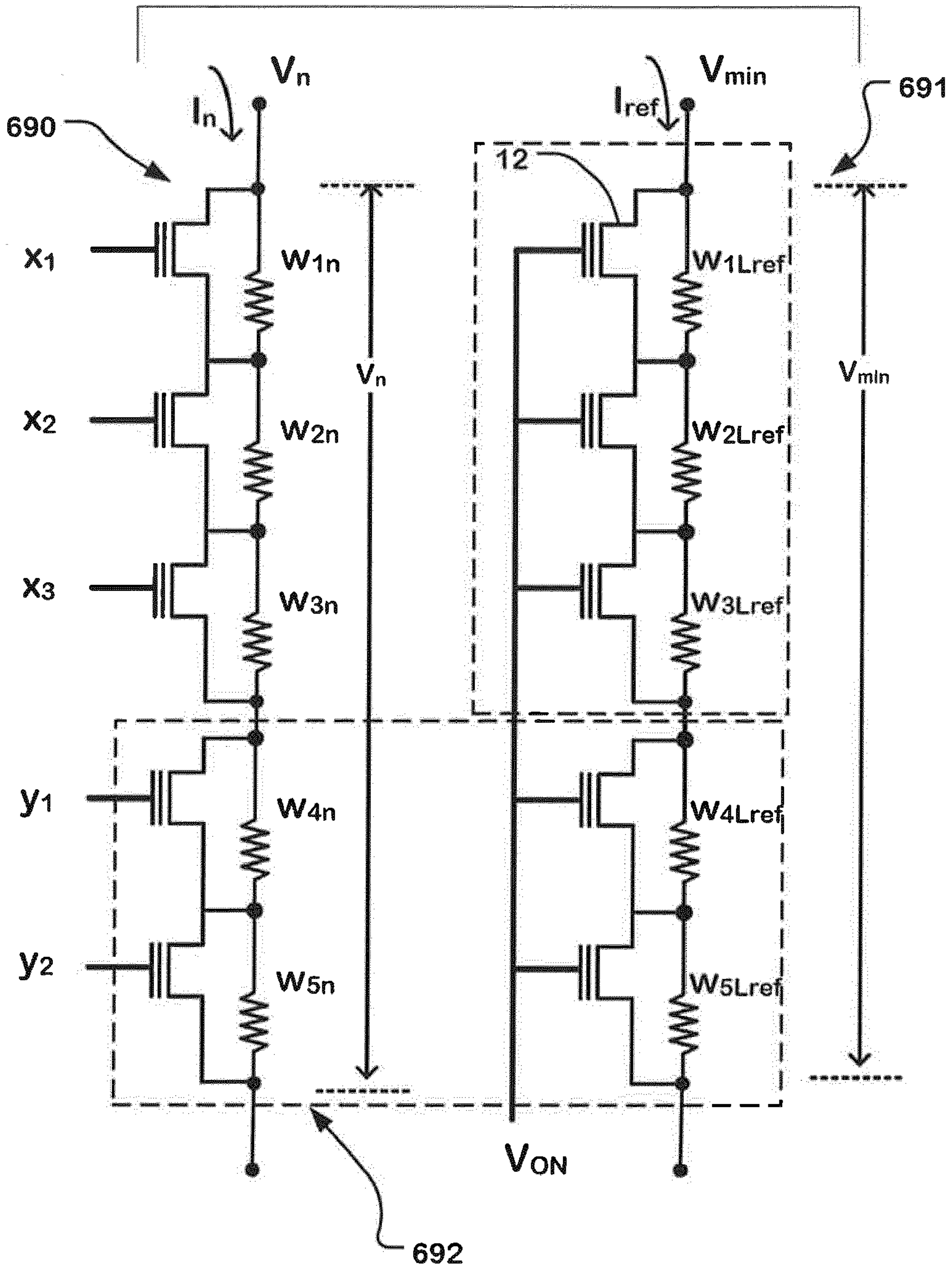
Vn
In
Vmin
Iref
690
691
12
x1
x2
x3
y1
y2
W1n
W2n
W3n
W4n
W5n
W1Lref
W2Lref
W3Lref
W4Lref
W5Lref
Vn
Vmin
VON
692

FIG. 16

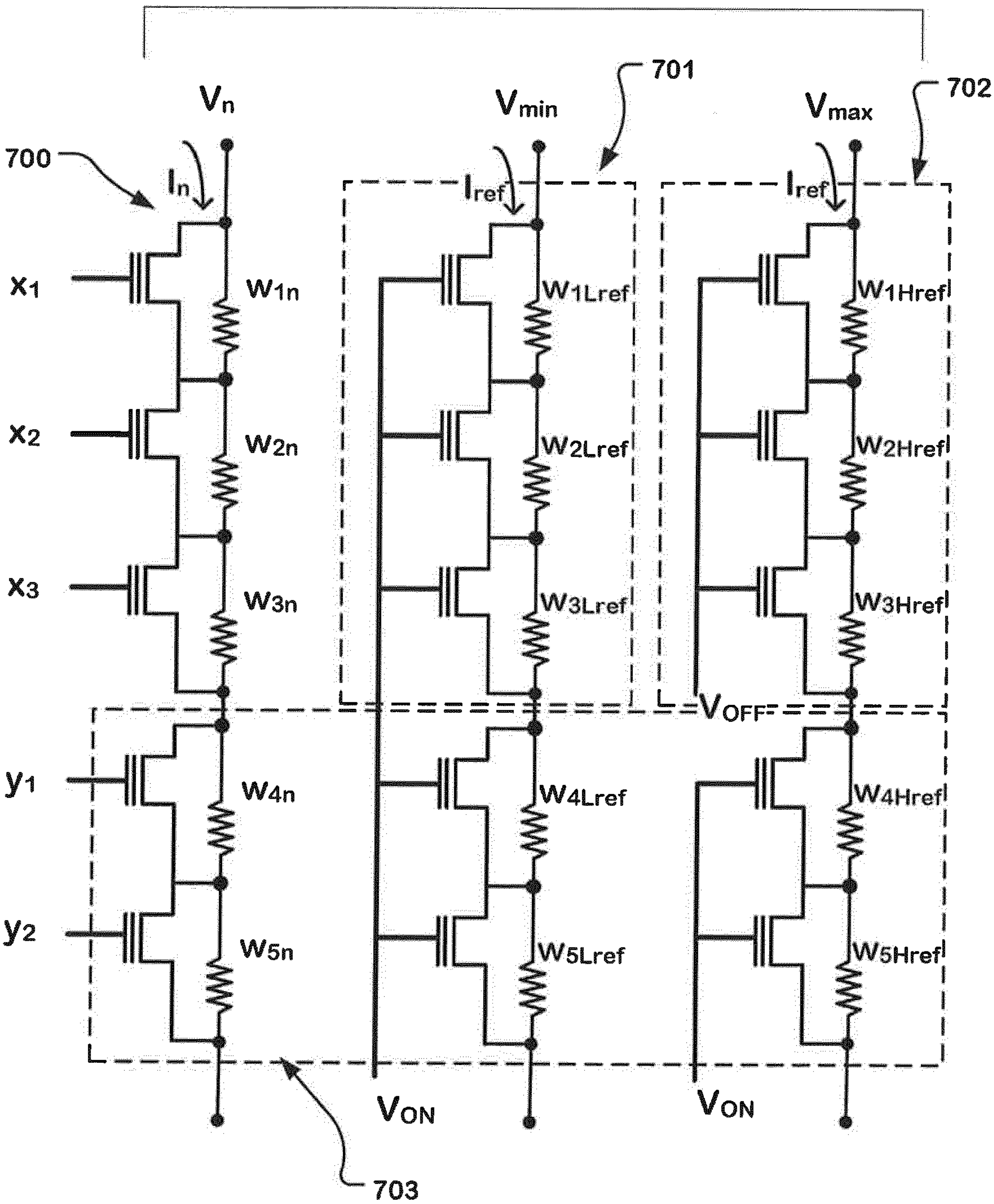
Vn
In
700
Vmin
Iref
701
Vmax
Iref
702
x1
x2
x3
W1n
W2n
W3n
W1Lref
W2Lref
W3Lref
W1Href
W2Href
W3Href
VOFF
y1
y2
W4n
W5n
W4Lref
W5Lref
W4Href
W5Href
VON
VON
703

FIG. 17

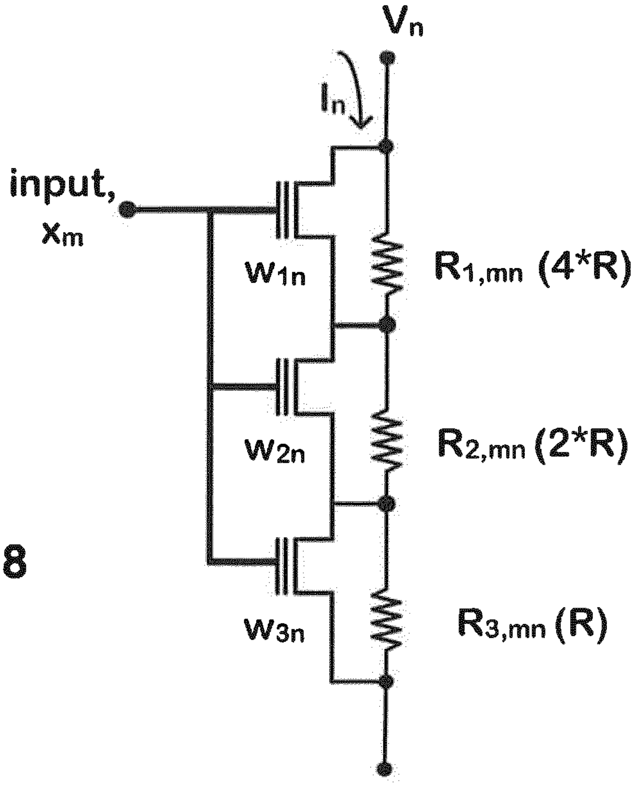
Vn
In
input,
xm
W1n
R1,mn (4*R)
W2n
R2,mn (2*R)
W3n
R3,mn (R)

FIG. 18

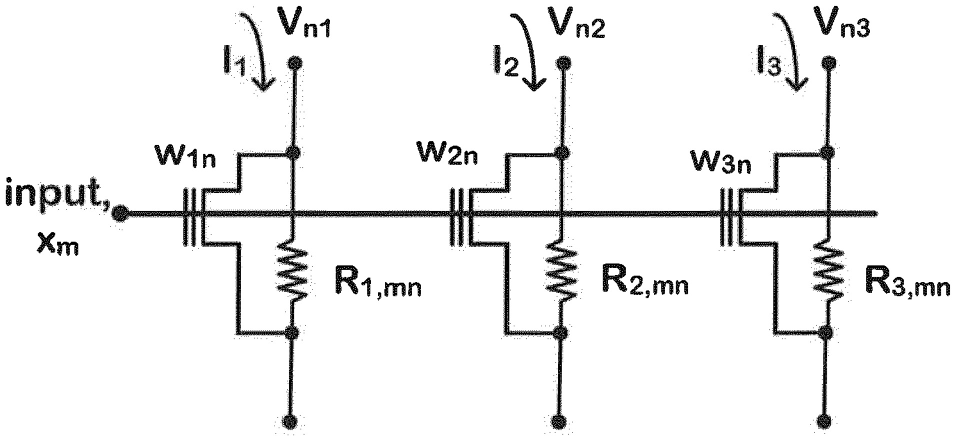
Vn1
I1
Vn2
I2
Vn3
I3
W1n
W2n
W3n
input,
xm
R1,mn
R2,mn
R3,mn

FIG. 19

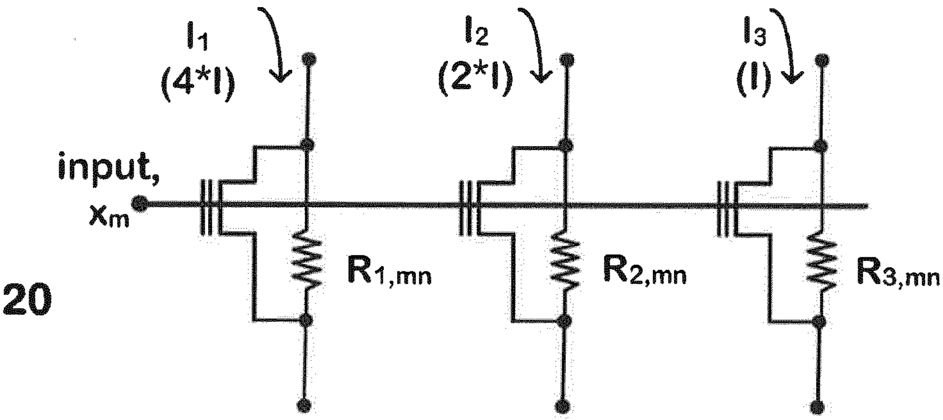


FIG. 20

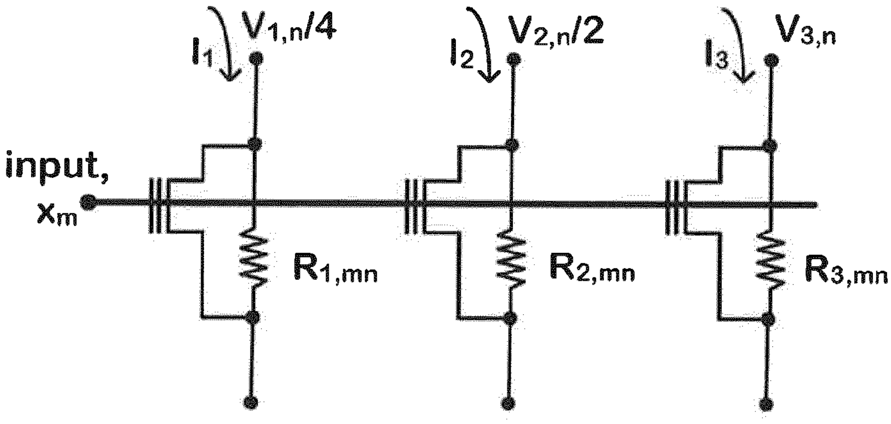


FIG. 21

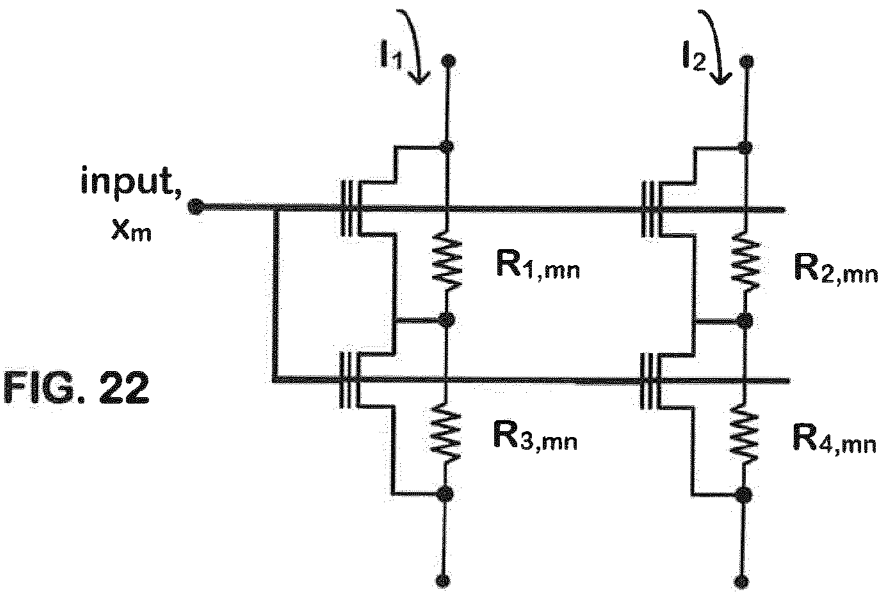


FIG. 22

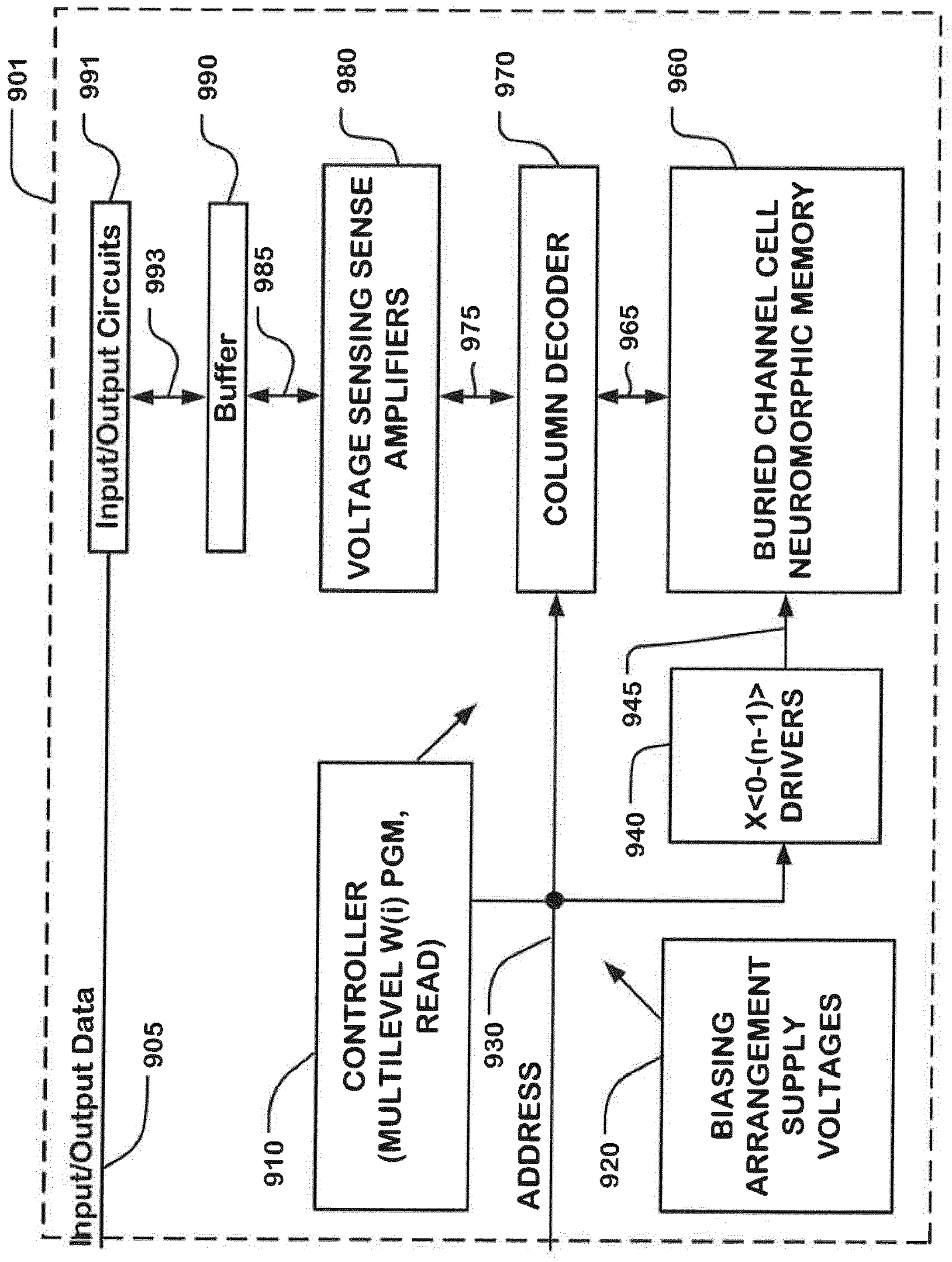
901
991
Input/Output Circuits
993
990
Buffer
985
980
VOLTAGE SENSING SENSE AMPLIFIERS
975
970
COLUMN DECODER
965
960
BURIED CHANNEL CELL NEUROMORPHIC MEMORY
Input/Output Data
905
910
CONTROLLER (MULTILEVEL W(i) PGM, READ)
930
ADDRESS
940
945
X<0-(n-1)> DRIVERS
920
BIASING ARRANGEMENT SUPPLY VOLTAGES

FIG. 23

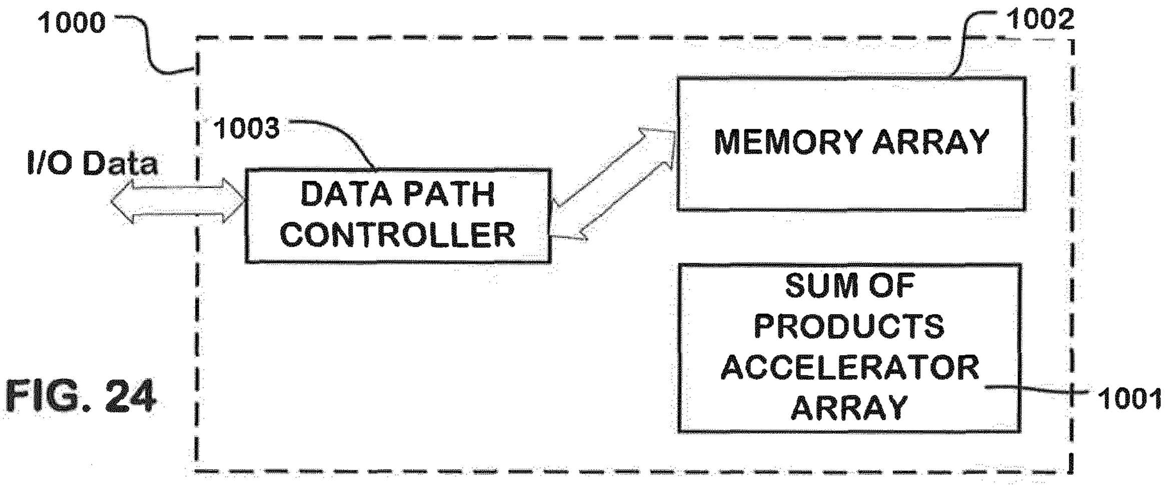


FIG. 24

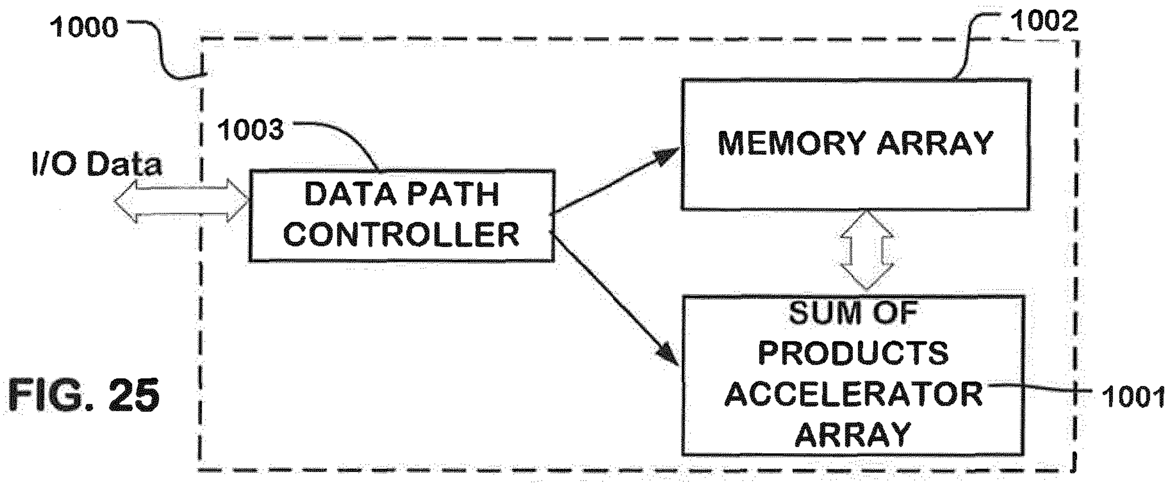


FIG. 25

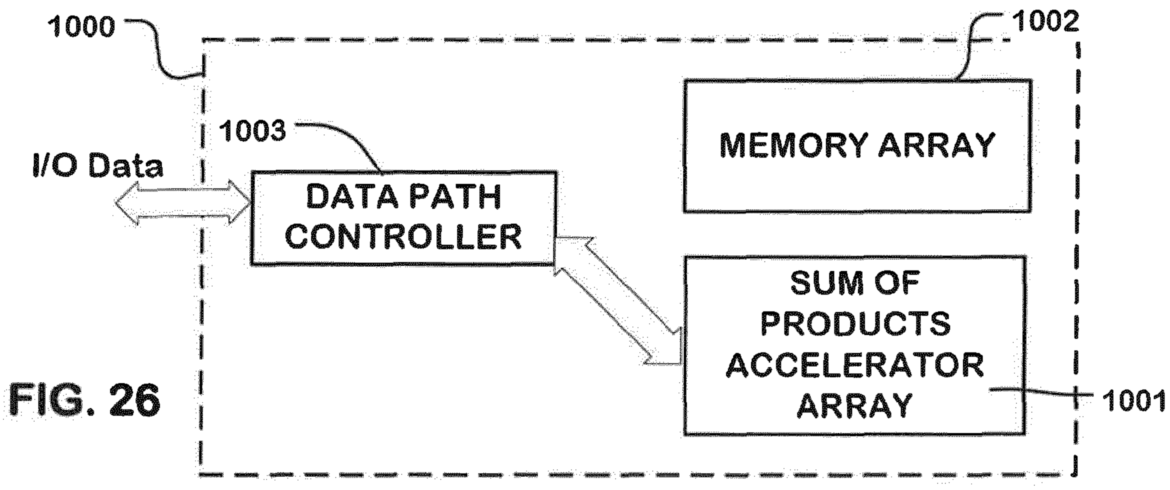


FIG. 26

Europäisches Patentamt
European Patent Office
Office européen des brevets

# EUROPEAN SEARCH REPORT

Application Number
EP 18 15 8099

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/286258 A1 (CHEN YI-CHOU [TW] ET AL) 24 November 2011 (2011-11-24) * paragraph [0045] - paragraph [0056]; figures 1-3 * ----- | 1-15 | INV. G11C11/54 G11C16/04 |
| X | US 2012/044742 A1 (NARAYANAN VENKAT [US]) 23 February 2012 (2012-02-23) * paragraph [0019] - paragraph [0020]; figure 3 * ----- | 1-15 | |
| A | Daniel Soudry ET AL: "Hebbian learning rules with memristors", Center for Communication and Information Technologies (CCIT) Report #840, 1 September 2013 (2013-09-01), XP055196510, Retrieved from the Internet: URL:http://wayback.archive.org/web/20131021065703/http://webee.technion.ac.il/people/skva/Hebbian learning paper.pdf [retrieved on 2015-06-17] * the whole document * ----- | 1-15 | TECHNICAL FIELDS SEARCHED (IPC) |
| A | US 2016/336064 A1 (SEO JAE-SUN [US] ET AL) 17 November 2016 (2016-11-17) * paragraph [0025] - paragraph [0062]; figure 1 * ----- | 1-15 | G11C |

The present search report has been drawn up for all claims

2

| Place of search | Date of completion of the search | Examiner |
|---|---|---|
| The Hague | 12 September 2018 | Lecoutre, Renaud |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 18 15 8099

This annex lists the patent family members relating to the patent documents cited in the above-mentioned European search report. The members are as contained in the European Patent Office EDP file on
The European Patent Office is in no way liable for these particulars which are merely given for the purpose of information.

12-09-2018

| Patent document cited in search report | Publication date | Patent family member(s) | Publication date |
| --- | --- | --- | --- |
| US 2011286258 A1 | 24-11-2011 | NONE | |
| US 2012044742 A1 | 23-02-2012 | TW 201214437 A<br>US 2012044742 A1<br>WO 2012024079 A2 | 01-04-2012<br>23-02-2012<br>23-02-2012 |
| US 2016336064 A1 | 17-11-2016 | NONE | |

EPO FORM P0459

For more details about this annex : see Official Journal of the European Patent Office, No. 12/82